# EUROPEAN PATENT APPLICATION

(11) **EP 4 492 947 A1**
(43) Date of publication of application: **15.01.2025**
(21) Application number: 24187339.7
(22) Date of filing: 09.07.2024
(51) Int. Cl.: H10K 59/80

(54) **DISPLAY DEVICE**

(30) Priority: 13.07.2023 KR 20230091019
(71) Applicant: Samsung Display Co., Ltd., Gyeonggi-do 17113 (KR)
(72) Inventor: JEONG, Seongjin, 17113 Giheung-Gu, Yongin-si (KR); PARK, Ilhoo, 17113 Giheung-Gu, Yongin-si (KR); BANG, Jinsook, 17113 Giheung-Gu, Yongin-si (KR); SONG, Jinouk, 17113 Giheung-Gu, Yongin-si (KR); YIM, Sanghoon, 17113 Giheung-Gu, Yongin-si (KR)
(74) Representative: Dr. Weitzel & Partner

(57) **Abstract**

A display device includes a display module and a window module. The display module includes a base layer, a light emitting element layer that is on the base layer and includes a light emitting element, an encapsulation layer on the light emitting element layer, and a color filter layer on the encapsulation layer. The light emitting element includes a first electrode, a second electrode that is on the first electrode and includes transparent conductive metal oxide, and a light emitting layer between the first electrode and the second electrode, and a distance between the first electrode and the second electrode is a primary resonance distance for light emitted from the light emitting layer. The encapsulation layer includes a single first inorganic layer directly on the light emitting element layer, an organic layer on the first inorganic layer, and a second inorganic layer on the organic layer.

## Description

### BACKGROUND

### 1. Field

The present invention relates to a display device.

### 2. Description of the Related Art

Display devices are used in various suitable multimedia devices, such as televisions, mobile phones, tablet computers, game machines, and the like, to provide image information to users.

A display device includes a display module and a window module. A window included in the display device effectively transfers image information provided from the display module to the outside and protects the display module from the outside.

The display module includes a light emitting element layer, and the light emitting element layer includes a first electrode, a second electrode, and a light emitting layer. In addition, the light emitting element layer may further include functional layers such as a hole transport region and an electron transport region.

The above information disclosed in this Background section is only for enhancement of understanding of the background of the invention and therefore it may contain information that does not form the prior art.

### SUMMARY

Aspects according to the present invention are directed toward a display device for reducing light leakage from the periphery of the display device.

Aspects according to one or more embodiments of the present invention are directed toward a display device for reducing light leakage from the display device including a window including a curved surface at the periphery thereof.

An embodiment of the present invention is defined by claim 1. The dependent claims describe preferred embodiments.

Additional aspects will be set forth in part in the description which follows and, in part, will be apparent from the description, or may be learned by practice of the presented embodiments of the present invention.

According to an embodiment of the present invention, a display device includes a display module and a window module that is on the display module and that includes a front surface including a flat region and a curved region around the flat region. The display module includes a base layer, a light emitting element layer that is on the base layer and that includes a light emitting element. The light emitting element includes a first electrode, a second electrode that is disposed on the first electrode and that includes transparent conductive metal oxide, and a light emitting layer disposed between the first electrode and the second electrode, and a distance between the first electrode and the second electrode is a primary resonance distance for light emitted from the light emitting layer. The display module further includes an encapsulation layer on the light emitting element layer, and a color filter layer on the encapsulation layer. The encapsulation layer includes a single first inorganic layer directly on the light emitting element layer, an organic layer on the first inorganic layer, and a second inorganic layer disposed on the organic layer.

The primary resonance distance for light refers to the distance at which the light emitted from the light-emitting layer in the outward direction and emitted to the outside resonates for the first time with the light emitted from the light-emitting layer reflected at the interface of the first electrode.

According to some embodiments, the distance between the first electrode and the second electrode may be in a range from about 70 nm (700 Å) to about 130 nm (1300 Å).

According to some embodiments, the light emitting layer may have a refractive index of about 1.8 to about 1.95.

According to some embodiments, the light emitting element may further include a hole transport region between the first electrode and the light emitting layer, and a distance between the first electrode and the light emitting layer may be in a range from about 10 nm (100 Å) to about 40 nm (400 Å).

According to some embodiments, the light emitting element may further include an electron transport region between the light emitting layer and the second electrode, and the hole transport region and the electron transport region may have a refractive index of about 1.8 to about 2.0.

According to some embodiments, the second electrode may include at least one of indium zinc oxide (IZO), indium tin oxide (ITO), zinc oxide (ZnO), or indium tin zinc oxide (ITZO).

According to some embodiments, the second electrode may have a thickness of about 50 nm (500 Å) to about 80 nm (800 Å).

According to some embodiments, the display module may further include a polarizer film on the color filter layer.

According to some embodiments, a luminance reduction percentage per angle within the window module of light emitted from the display module may be about 2% / dgr or less based on luminance of light emitted in a direction parallel to a direction from the display module to the window module.

According to some embodiments, a luminance reduction percentage per angle of light emitted from the display module and outputted through the window module may be about 1 % / dgr or less based on luminance of light emitted in a direction parallel to a direction from the display module to the window module.

According to some embodiments, the light emitting layer may include a first light emitting layer and a second light emitting layer on the first light emitting layer.

According to some embodiments of the invention, a display device includes a display module including a first region and a second region around the first region and a window module that is on the display module and that includes a front surface including a flat region that overlaps the first region on a plane (e.g., in a plan view) and a curved region around the flat region. The display module includes a base layer, a light emitting element layer including a first light emitting element in the first region and a second light emitting element in the second region. The second light emitting element includes a first electrode, a second electrode that is disposed on the first electrode and that includes transparent conductive metal oxide, and a first light emitting layer disposed between the first electrode and the second electrode, and a distance between the first electrode and the second electrode is a primary resonance distance for light emitted from the first light emitting layer. The display module may further include an encapsulation layer on the light emitting element layer. The encapsulation layer includes a single first inorganic layer directly disposed on the light emitting element layer, an organic layer disposed on the first inorganic layer, and a second inorganic layer disposed on the organic layer. The display module may further include a color filter layer on the encapsulation layer. The encapsulation layer includes a single first inorganic layer directly disposed on the light emitting element layer, an organic layer disposed on the first inorganic layer, and a second inorganic layer disposed on the organic layer.

According to some embodiments, the distance between the first electrode and the second electrode may be in a range from about 70 nm (700 Å) to about 130 nm (1300 Å).

According to some embodiments, the first light emitting element may include a third electrode, a fourth electrode on the third electrode, and a second light emitting layer between the third electrode and the fourth electrode, and a distance between the third electrode and the fourth electrode of the first light emitting element may be greater than the distance between the first electrode and the second electrode of the second light emitting element.

According to some embodiments, the distance between the third electrode and the fourth electrode of the first light emitting element may be a secondary resonance distance for light emitted from the second light emitting layer of the first light emitting element.

According to some embodiments, the distance between the third electrode and the fourth electrode of the first light emitting element may be in a range from about 190 nm (1900 Å) to about 310 nm (3100 Å).

According to some embodiments, the fourth electrode of the first light emitting element may include translucent conductive metal oxide.

According to some embodiments, the second region may surround the first region on a plane (e.g., in a plan view), and the curved region may surround the flat region on a plane (e.g., in a plan view).

According to some embodiments, a distance between the second region and the curved region may be less than a distance between the second region and the first region on a plane (e.g., in a plan view).

According to some embodiments, the second region may overlap the curved region on a plane (e.g., in a plan view).

According to some embodiments, a luminance reduction percentage per angle within the window module of light emitted from the second region of the display module may be about 2% / dgr or less based on luminance of light emitted in a direction parallel to a direction from the display module to the window module.

According to some embodiments, a luminance reduction percentage per angle of light emitted from the second region of the display module and outputted through the window module may be about 1 % / dgr or less based on luminance of light emitted in a direction parallel to a direction from the display module to the window module.

According to some embodiments of the invention, a display device includes a base layer, a light emitting element layer that is on the base layer and that includes a first color light emitting element, a second color light emitting element, and a third color light emitting element that is configured to emit first color light, second color light, and third color light in different wavelength regions, respectively. Each of the first to third color light emitting elements includes a first electrode, a second electrode that is disposed on the first electrode and that includes transparent conductive metal oxide, and a light emitting layer disposed between the first electrode and the second electrode. A distance between the first electrode and the second electrode of the first color light emitting element corresponds to a primary resonance distance of the first color light, a distance between the first electrode and the second electrode of the second color light emitting element corresponds to a primary resonance distance of the second color light, and a distance between the first electrode and the second electrode of the third color light emitting element corresponds to a primary resonance distance of the third color light. The display device may further include an encapsulation layer including a single first inorganic layer directly on the light emitting element layer, an organic layer on the first inorganic layer, and a second inorganic layer on the organic layer, a color filter layer that is disposed on the encapsulation layer and that includes a color filter that overlaps the second color light emitting element on a plane (e.g., in a plan view) and not overlapping the first color light emitting element and the third color light emitting element on the plane (e.g., in a plan view), a polarizer film on the color filter layer, and a window that is on the polarizer film and that includes a front surface including a flat region and a curved region around the flat region.

According to some embodiments, the distance between the first electrode and the second electrode of the first color light emitting element may be in a range from about 110 nm (1100 Å) to about 130 nm (1300 Å).The distance between the first electrode and the second electrode of the second color light emitting element may be in a range from about 90 nm (900 Å) to about 110 nm (1100 Å).The distance between the first electrode and the second electrode of the third color light emitting element may be in a range from about 70 nm (700 Å) to about 90 nm (900 Å).

According to some embodiments, a distance between the first electrode and the light emitting layer in the first color light emitting element may be in a range from about 30 nm (300 Å) to about 40 nm (400 Å).A distance between the first electrode and the light emitting layer in the second color light emitting element may be in a range from about 15 nm (150 Å) to about 25 nm (250 Å).A distance between the first electrode and the light emitting layer in the third color light emitting element may be in a range from about 10 nm (100 Å) to about 20 nm (200 Å).

### BRIEF DESCRIPTION OF THE DRAWINGS

The above and other objects and features of the present invention will become apparent by describing in detail embodiments thereof with reference to the accompanying drawings.
FIG. 1A is an assembled perspective view illustrating an unfolded state of a display device according to some embodiments of the present invention.
FIG. 1B is an assembled perspective view illustrating an in-folded state of the display device according to some embodiments of the present invention.
FIG. 1C is an assembled perspective view illustrating an out-folded state of the display device according to some embodiments of the present invention.
FIG. 2A is an assembled perspective view illustrating an unfolded state of a display device according to some embodiments of the present invention.
FIG. 2B is an assembled perspective view illustrating an in-folded state of the display device according to some embodiments of the present invention.
FIG. 3 is an exploded perspective view of a display device according to some embodiments of the present invention.
FIGS. 4A and 4B are cross-sectional views of the display device according to some embodiments of the present invention.
FIGS. 5A and 5B are cross-sectional views of portions of display modules according to some embodiments of the present invention.
FIGS. 6A- 6D are cross-sectional views of light emitting elements according to some embodiments of the present invention.
FIG. 7 is a schematic view illustrating optical characteristics in a portion of a display device according to some embodiments of the present invention.
FIGS. 8A-8C are resonance graphs of light emitted from light emitting elements according to some embodiments of the present invention.
FIG. 9A is a graph of luminance distribution of a substrate mode according to some embodiments of the present invention.
FIG. 9B is a graph of luminance reduction percentage per angle of the substrate mode according to an embodiment of the present invention.
FIG. 10A is a graph of luminance distribution of an air mode according to some embodiments of the present invention.
FIG. 10B is a graph of luminance reduction percentage per angle of the air mode according to some embodiments of the present invention.
FIG. 11A is a schematic view illustrating optical characteristics in a portion of a display device according to some embodiments of the present disclosure.
FIG. 11B is a cross-sectional view of a portion of a display module according to some embodiments of the present disclosure.
FIG. 12 is a schematic view illustrating optical characteristics in a portion of a display device according to comparative examples.
FIGS. 13A-13C are resonance graphs of light emitted from light emitting elements according to comparative examples.
FIG. 14A is a graph of luminance distribution of a substrate mode according to comparative examples.
FIG. 14B is a graph of luminance reduction percentage per angle of the substrate mode according to comparative examples.
FIG. 15A is a graph of luminance distribution of an air mode according to comparative examples.
FIG. 15B is a graph of luminance reduction percentage per angle of the air mode according to comparative examples.
FIGS. 16A-16C are resonance graphs of light emitted from light emitting elements according to comparative examples.
FIG. 17A is a graph of luminance distribution of a substrate mode according to comparative examples.
FIG. 17B is a graph of luminance reduction percentage per angle of the substrate mode according to comparative examples.
FIG. 18A is a graph of luminance distribution of an air mode according to comparative examples.
FIG. 18B is a graph of luminance reduction percentage per angle of the air mode according to comparative examples.
FIG. 19A is a graph of luminance distribution of the substrate mode according to comparative examples.
FIG. 19B is a graph of luminance reduction percentage per angle of the substrate mode according to comparative examples.
FIG. 20A is a graph of luminance distribution of the air mode according to comparative examples.
FIG. 20B is a graph of luminance reduction percentage per angle of the air mode according to comparative examples.
FIGS. 21A-21C are resonance graphs of light emitted from light emitting elements according to comparative examples.
FIG. 22A is a graph of luminance distribution of a substrate mode according to comparative examples.
FIG. 22B is a graph of luminance reduction percentage per angle of the substrate mode according to comparative examples.
FIG. 23A is a graph of luminance distribution of an air mode according to comparative examples.
FIG. 23B is a graph of luminance reduction percentage per angle of the air mode according to comparative examples.

### DETAILED DESCRIPTION

One or more suitable changes can be made to the present invention, and one or more suitable embodiments of the present invention may be implemented. Thus, particular embodiments are illustrated in the drawings and described as examples herein. However, it should be understood that the present disclosure is not to be construed as being limited thereto.

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

The expression "directly disposed" used herein may mean that there is no additional layer, film, area, or plate between one portion, such as a layer, a film, an area, or a plate, and another portion. For example, the expression "directly disposed" may mean that two layers or two members are disposed without an additional member such as an adhesive member therebetween.

Identical reference numerals refer to identical components. Additionally, in the drawings, the thicknesses, proportions, and dimensions of components are exaggerated for effective description.

As used herein, the term "and/or" includes all of one or more combinations defined by related components.

Terms such as first, second, and the like may be used to describe one or more suitable components, but the components should not be limited by the terms. The terms may be used only for distinguishing one component from other components. For example, without departing the scope of the present invention, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing. The expression "disposed on" used herein may mean that it is disposed not only on an upper portion but also a lower portion of any one member.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

As utilized herein, the term "and/or" includes any and all combinations of one or more of the associated listed items. Throughout the disclosure, the expression "at least one of a, b or c", "at least one of a-c", "at least one of a to c", "at least one of a, b, and/or c", "at least one among a to c", etc., indicates only a, only b, only c, both (e.g., simultaneously) a and b, both (e.g., simultaneously) a and c, both (e.g., simultaneously) b and c, all of a, b, and c, or variations thereof.

In the present specification, "including A or B", "A and/or B", etc., represents A or B, or A and B.

The electronic device, the electronic apparatus, the electronic equipment, or any other relevant devices or components according to embodiments of the present invention described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

Unless otherwise defined, all terms used herein, including technical or scientific terms, have the same meanings as those generally understood by those skilled in the art to which the present invention pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, a window and a display device according to some embodiments of the present invention will be described with reference to the accompanying drawings.

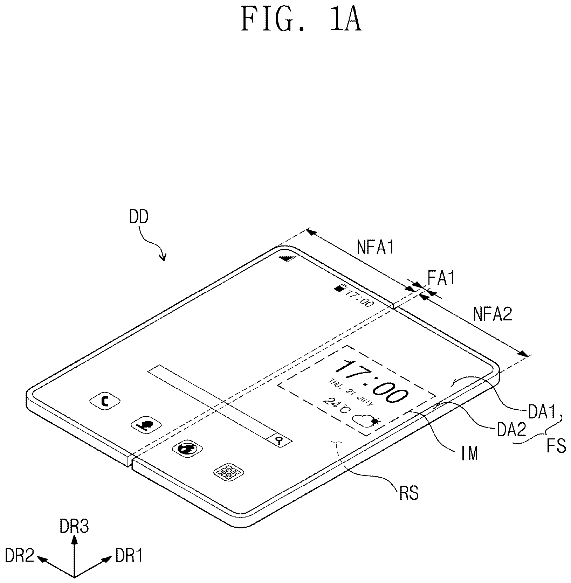

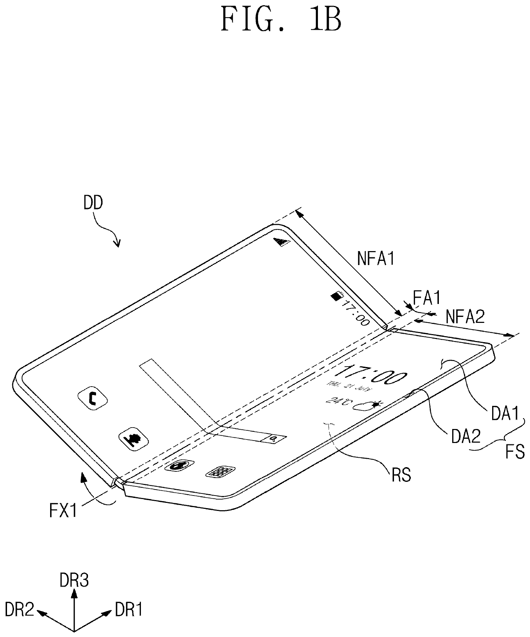

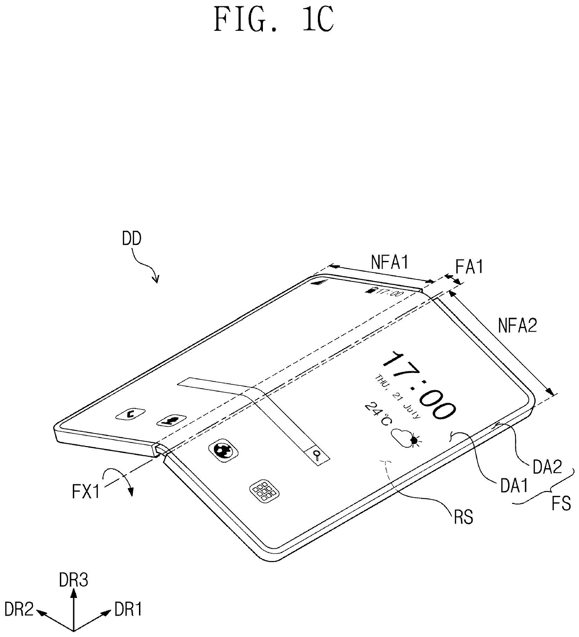

FIG. 1A is an assembled perspective view illustrating an unfolded state of the display device DD according to some embodiments of the present invention. FIG. 1B is an assembled perspective view illustrating an in-folded state of the display device DD according to some embodiments of the present invention. FIG. 1C is an assembled perspective view illustrating an out-folded state of the display device DD according to some embodiments of the present invention.

The display device DD of some embodiments may be a device activated depending on an electrical signal. For example, the display device DD may be a mobile phone, a tablet computer, a car navigation unit, a game machine, or a wearable device. However, embodiments of the present invention are not limited thereto. FIGS. 1A to 1C illustrate some examples in which the display device DD is a mobile phone.

Although a first direction DR1, a second direction DR2, and a third direction DR3 are illustrated in FIG. 1A and the following drawings, the directions indicated by the first to third directions DR1, DR2, and DR3 described in this specification may be relative concepts and may be changed to different directions.

Referring to FIGS. 1A to 1C, the display device DD according to some embodiments may include a first display surface FS defined by the first direction DR1 and the second direction DR2 crossing the first direction DR1. The display device DD may provide an image IM to a user through the first display surface FS. The display device DD may display the image IM in the third direction DR3 through the first display surface FS, the first display surface FS being parallel to the first direction DR1 and the second direction DR2. In this specification, front surfaces (or, upper surfaces) and rear surfaces (or, lower surfaces) of components are defined based on the direction in which the image IM is displayed. The front surfaces and the rear surfaces may be opposite to each other in the third direction DR3, and the normal directions of the front surfaces and the rear surfaces may be parallel to the third direction DR3.

The display device DD according to some embodiments may include the first display surface FS and a second display surface RS. The first display surface FS may include a first display region DA1 and a second display region DA2. The second display region DA2 may be disposed adjacent to the first display region DA1. For example, as illustrated in FIGS. 1A to 1C, the second display region DA2 may surround the first display region DA1. An electronic module region may be included in the first display region DA1. The second display surface RS may be defined as a surface facing away from at least a portion of the first display surface FS. For example, the second display surface RS may be defined as a portion of a rear surface of the display device DD.

The display device DD according to some embodiments may sense an external input applied from the outside. The external input may include one or more suitable types of inputs provided from outside the display device DD. For example, the external input may include not only being contacted by a part of the user's body, such as the user's hand, but also by an external input (e.g., hovering) that is applied in proximity to the display device DD or applied adjacent to the display device DD at a predetermined distance. Furthermore, the external input may have one or more suitable forms such as force, pressure, temperature, light, and the like.

The display device DD may include a folding region FA1 and non-folding regions NFA1 and NFA2. The display device DD may include the first non-folding region NFA1 and the second non-folding region NFA2 disposed with the folding region FA1 therebetween. In some embodiments, although FIGS. 1A to 1C illustrate some examples in which the display device DD includes one folding region FA1, embodiments of the present invention are not limited thereto, and the display device DD may have a plurality of folding regions defined therein.

Referring to FIG. 1B, the display device DD may be folded about a first folding axis FX1. The first folding axis FX1 may be a virtual axis extending in the first direction DR1. The first folding axis FX1 may be parallel to the direction of long sides of the display device DD. The first folding axis FX1 may extend in the first direction DR1 on the first display surface FS.

In some embodiments, the non-folding regions NFA1 and NFA2 may be disposed adjacent to the folding region FA1 with the folding region FA1 therebetween. For example, the first non-folding region NFA1 may be disposed on one side of the folding region FA1 in the second direction DR2, and the second non-folding region NFA2 may be disposed on an opposite side of the folding region FA1 in the second direction DR2.

The display device DD may be folded about the first folding axis FX1 and may be changed to the in-folded state in which one region of the first display surface FS that overlaps the first non-folding region NFA1 and an opposite region of the first display surface FS that overlaps the second non-folding region NFA2 face each other. When the display device DD is in the in-folded state, the second display surface RS may be visible to the user. The second display surface RS may further include an electronic module region in which an electronic module including one or more suitable components is disposed, and the present invention is not limited to any one embodiment.

Referring to FIG. 1C, the display device DD may be folded about the first folding axis FX1 and may be changed to the out-folded state in which one region of the second display surface RS that overlaps the first non-folding region NFA1 and an opposite region of the second display surface RS that overlaps the second non-folding region NFA2 face each other. However, embodiments of the present invention are not limited thereto. The display device DD may be folded about a plurality of folding axes such that a portion of the first display surface FS and a portion of the second display surface RS face each other, and the number of folding axes and the number of non-folding regions are not particularly limited.

The display device DD may further include one or more suitable electronic modules. For example, the electronic modules may include at least one of a camera, a speaker, a light detection sensor, or a heat detection sensor. The electronic modules may sense an external object received through the first or second display surface FS or RS, or may provide a sound signal, such as voice, to the outside through the first or second display surface FS or RS. The electronic modules may include a plurality of components and are not limited to any one embodiment.

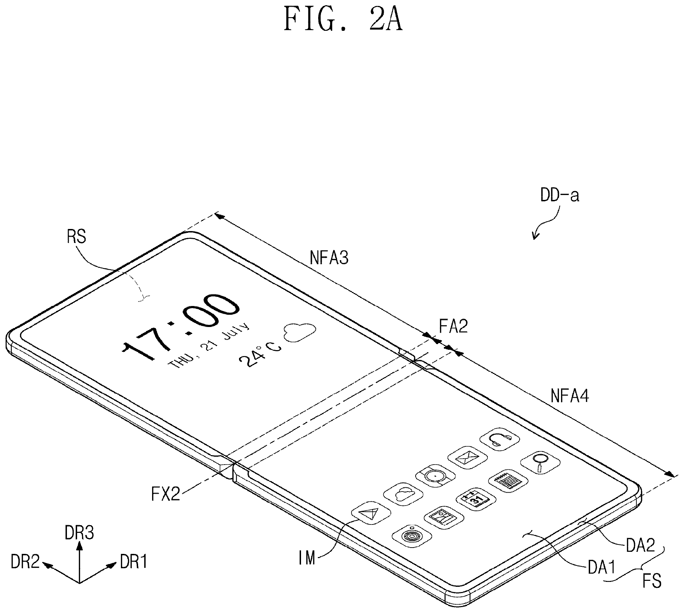

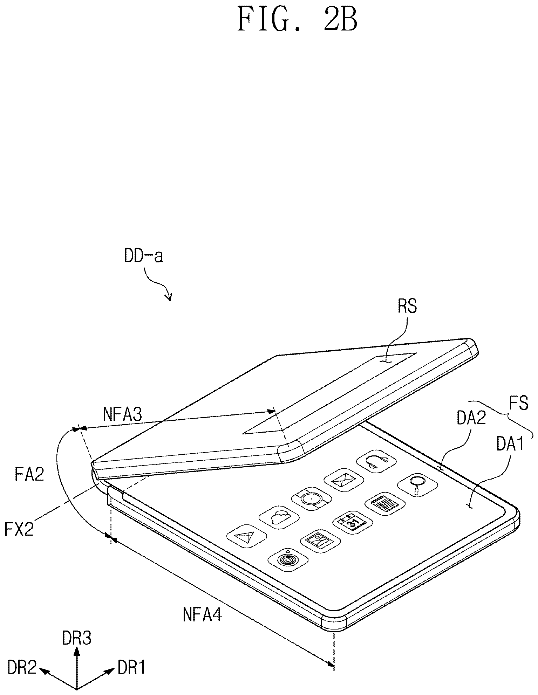

FIG. 2A is an assembled perspective view illustrating an unfolded state of a display device DD-a according to some embodiments of the present invention. FIG. 2B is an assembled perspective view illustrating an in-folded state of the display device DD-a according to some embodiments of the present invention.

The display device DD-a may be folded about a second folding axis FX2 extending in one direction (e.g., an extension direction) parallel to the first direction DR1. FIGS. 2A and 2B illustrate an example that the extension direction of the second folding axis FX2 is parallel to the extension direction of short sides of the display device DD-a. However, embodiments of the present invention are not limited thereto.

The display device DD-a according to some embodiments may include at least one folding region FA2 and non-folding regions NFA3 and NFA4 adjacent to the folding region FA2. The non-folding regions NFA3 and NFA4 may be spaced apart from each other with the folding region FA2 therebetween.

In some embodiments, the display device DD-a may be folded in an in-folding manner such that the third non-folding region NFA3 and the fourth non-folding region NFA4 face each other and a first display surface FS is not exposed to the outside. In some embodiments, unlike that illustrated in FIG. 2B, the display device DD-a may be folded in an out-folding manner such that the first display surface FS is exposed to the outside. The display device DD-a may include the first display surface FS and a second display surface RS. The first display surface FS may include a first display region DA1 and a second display region DA2. In some embodiments, the display device DD-a may further include one or more suitable electronic modules.

The display devices DD and DD-a described with reference to FIGS. 1A to 1C, 2A, and 2B may be configured such that an in-folding operation and an out-folding operation are repeated in an unfolded state. However, embodiments of the present invention are not limited thereto. In some embodiments, the display devices DD and DD-a may be configured to select one of an unfolding operation, an in-folding operation, and an out-folding operation. In some embodiments, a display device according to some embodiments may include a plurality of folding regions, or may be a flexible display device that is at least partially bent or rolled.

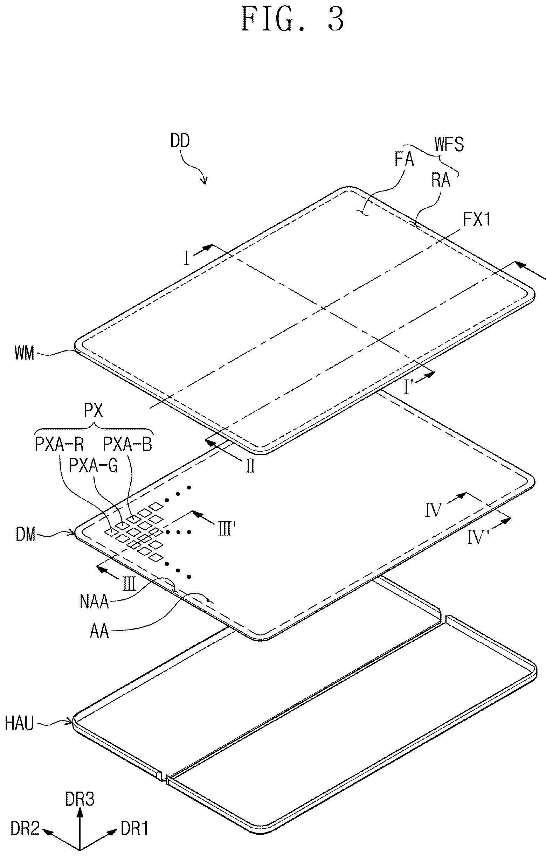

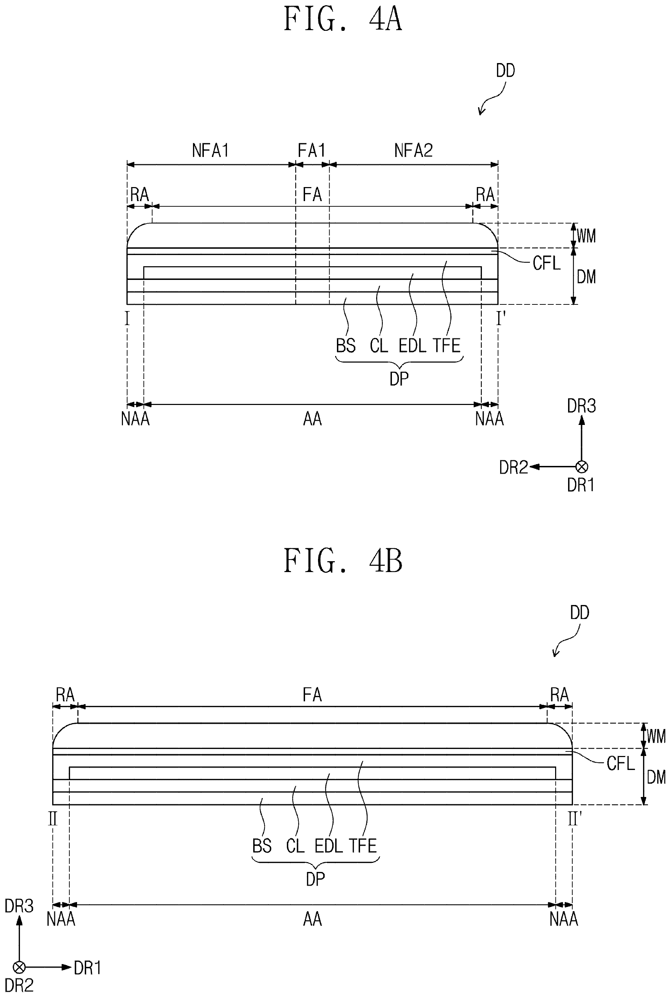

FIG. 3 is an exploded perspective view of the display device DD according to some embodiments of the present invention. FIGS. 4A and 4B are cross-sectional views of the display device DD according to some embodiments of the present invention.

FIG. 3 illustrates an exploded perspective view of the display device DD according to the embodiment illustrated in FIG. 1A. FIG. 4A illustrates a section corresponding to line I-I' of FIG. 3. FIG. 4B illustrates a section corresponding to line II-II' of FIG. 3.

Referring to FIG. 3, the display device DD may include a display module DM and a window module WM disposed on the display module DM. The window module WM may be disposed on and/or under the display module DM. FIG. 3 illustrates some examples in which the window module WM is disposed on the display module DM.

The display device DD may further include an electronic module that is disposed under the display module DM. For example, the electronic module may include a camera module.

The display device DD may further include an adhesive layer that is disposed between the window module WM and the display module DM. The adhesive layer may be an optically clear adhesive (OCA) film or an optically clear adhesive resin (OCR) layer.

The display device DD may further include a lower functional layer that is disposed under the display module DM. The lower functional layer may be a layer for supporting the display module DM or preventing deformation of the display module DM by an external impact or force. The lower functional layer may include at least one of a cushion layer, a support plate, a shielding layer, a filling layer, or an interlayer adhesion layer.

The display device DD may further include a housing HAU that accommodates the display module DM and the lower functional layer. The housing HAU may be coupled with the window module WM to form an exterior of the display device DD. The housing HAU may include a material having a relatively high rigidity. For example, the housing HAU may include a plurality of frames and/or plates formed of glass, plastic, metal, or the like. The display module DM may be accommodated in a receiving space and may be protected from an external impact. In some embodiments, the housing HAU may further include a hinge structure for facilitating folding or bending.

The display module DM may display the image IM depending on an electrical signal and may transmit/receive information about an external input.

Referring to FIG. 3, the display module DM may include an active region AA and a peripheral region NAA. The active region AA may be a region that provides the image IM (refer to, e.g., FIG. 1A). The active region AA may include pixels PX. The peripheral region NAA may be adjacent to the active region AA. The peripheral region NAA may surround the active region AA. Accordingly, the shape of the active region AA may be substantially defined by the peripheral region NAA. However, this is illustrative, and the peripheral region NAA may be disposed adjacent to only one side of the active region AA, or may be omitted. The display device DD may include active regions AA having one or more suitable shapes and is not limited to any one embodiment. A drive circuit or drive wiring for driving the active region AA may be disposed in the peripheral region NAA.

The display devices DD and DD-a illustrated in FIGS. 1A to 4B are illustrated as including four curved surfaces bent from four sides of a plane defined by the first direction DR1 and the second direction DR2. However, the number of curved surfaces is not limited thereto, and for example, the display devices DD and DD-a may include two curved surfaces bent from opposite sides of the plane defined by the first direction DR1 and the second direction DR2. Here, a region including the four curved surfaces may be referred to as the second display region DA2 (refer to, e.g., FIG. 1A) of the display device DD or a curved region RA of the window module WM.

The display module DM may include the plurality of pixels PX. Each of the pixels PX may be configured to emit light in response to an electrical signal. Light emitted from the pixels PX may implement the image IM (refer to, e.g., FIG. 1A). Each of the pixels PX may include a display element. For example, the display element may be an organic light emitting element, an inorganic light emitting element, an organic-inorganic light emitting element, a micro-LED, a nano-LED, a quantum-dot light emitting element, an electrophoretic element, an electrowetting element, or the like.

The pixels PX may include first color pixels PXA-R, second color pixels PXA-G, and third color pixels PXA-B spaced apart from one another on the plane (e.g., in a plan view). The first color pixels PXA-R, the second color pixels PXA-G, and the third color pixels PXA-B may be referred to as red light emitting regions PXA-R, green light emitting regions PXA-G, and blue light emitting regions PXA-B, respectively.

In the display device DD, the light emitting regions PXA-R, PXA-G, and PXA-B may be arranged in a stripe form. The plurality of red light emitting regions PXA-R, the plurality of green light emitting regions PXA-G, and the plurality of blue light emitting regions PXA-B may each be arranged in the second direction DR2. In some embodiments, the light emitting regions PXA-R, PXA-G, and PXA-B may be alternately arranged in the first direction DR1 in the order of the red light emitting region PXA-R, the green light emitting region PXA-G, and the blue light emitting region PXA-B.

An arrangement of the light emitting regions PXA-R, PXA-G, and PXA-B is not limited to that illustrated in FIG. 3, and a sequence in which the first light emitting region PXA-R, the second light emitting region PXA-G, and the third light emitting region PXA-B are arranged may be diversely provided in combination depending on characteristics of display quality that are desired for the display device DD. For example, the light emitting regions PXA-R, PXA-G, and PXA-B may be arranged in a PENTILE^{®} form or a diamond form.

In FIG. 3, the light emitting regions PXA-R, PXA-G, and PXA-B are illustrated as having similar areas. However, embodiments of the present invention are not limited thereto, and the areas of the light emitting regions PXA-R, PXA-G, and PXA-B may differ from one another depending on wavelength regions of emitted light. For example, in some embodiments, the green light emitting regions PXA-G may have a smaller area than the blue light emitting regions PXAS-B. However, embodiments of the present invention are not limited thereto. The areas of the light emitting regions PXA-R, PXA-G, and PXA-B may refer to areas viewed from above the plane defined by the first direction DR1 and the second direction DR2.

Referring to FIGS. 4A and 4B, the display module DM may include a display panel DP and a color filter layer CFL disposed on the display panel DP. The display module DM may further include a sensor layer that is disposed on the display panel DP.

The display panel DP may include a base layer BS, a circuit layer CL, a light emitting element layer EDL, and an encapsulation layer TFE.

The base layer BS may be a member that provides a base surface on which the circuit layer CL is disposed. The base layer BS may be a rigid substrate, or may be a flexible substrate that is bendable, foldable, or rollable. The base layer BS may be a glass substrate, a metal substrate, a polymer substrate, or the like. However, embodiments of the present invention are not limited thereto, and the base layer BS may be an inorganic layer, an organic layer, a composite layer, or the like.

The circuit layer CL may be disposed on the base layer BS. The circuit layer CL may include an insulating layer, a semiconductor pattern, a conductive pattern, and a signal line. An insulating layer, a semiconductor layer, and a conductive layer may be formed on the base layer BS by a process such as coating or deposition and may be selectively subjected to patterning by performing a photolithography process and an etching process a plurality of times. Thereafter, the semiconductor pattern, the conductive pattern, and the signal line included in the circuit layer CL may be formed.

The light emitting element layer EDL may be disposed on the circuit layer CL. The light emitting element layer EDL may include light emitting elements. For example, the light emitting elements may include an organic light emitting material, an inorganic light emitting material, an organic-inorganic light emitting material, a quantum dot, a quantum rod, a micro-LED, a nano-LED, or the like.

The encapsulation layer TFE may be disposed on the light emitting element layer EDL. The encapsulation layer TFE may cover the light emitting element layer EDL. The encapsulation layer TFE may be disposed in the active region AA where the light emitting element layer EDL is disposed and may generally extend to the peripheral region NAA where the light emitting element layer EDL is not disposed. The encapsulation layer TFE may protect the light emitting element layer EDL from foreign matter such as moisture, oxygen, dust particles, and the like.

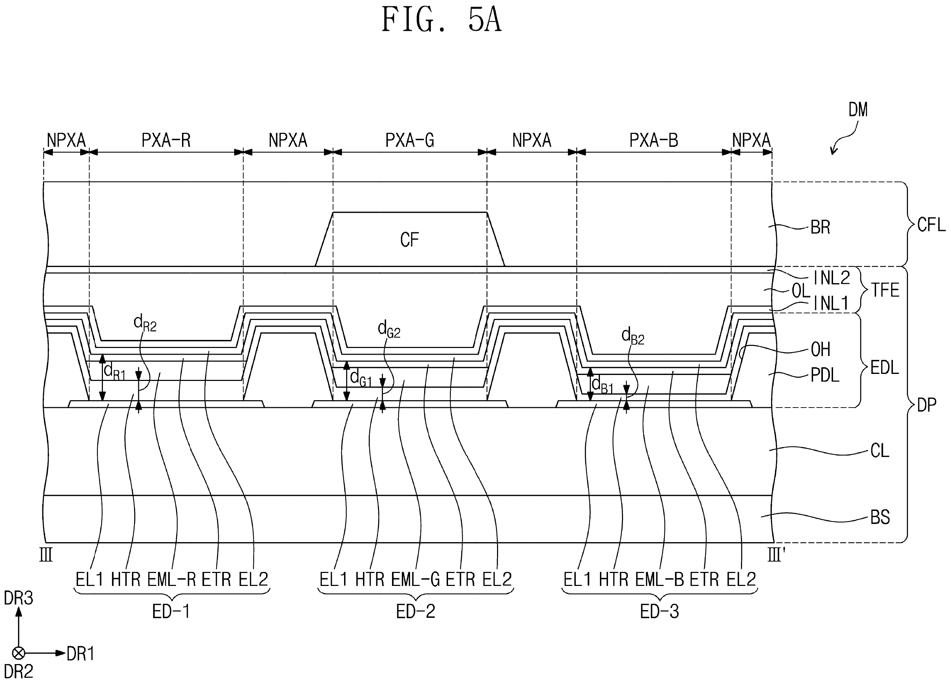

The color filter layer CFL may be disposed on the display panel DP. The color filter layer CFL may be formed through a continuous process. The color filter layer CFL will be described below with reference to FIG. 5A.

The display module DM may further include a polarizer film (not illustrated) that is disposed on the color filter layer CFL. The polarizer film may be a film including an optical function for improving light extraction efficiency of the display module DM and reducing reflectance by external light.

The display module DM may further include the sensor layer that is disposed on the display panel DP. The sensor layer may sense an external input applied from the outside. The external input may be a user input. The user input may include one or more suitable types of external inputs, such as a part of the user's body, light, heat, a pen, pressure, or the like.

The window module WM may be disposed on the display module DM. The window module WM may alleviate an external impact while transmitting an image from the display module DM. Accordingly, the window module WM may prevent damage or malfunction of the display module DM by an external impact.

The window module WM may cover the entire upper surface of the display module DM. The window module WM may have a shape generally corresponding to the shape of the display module DM. The window module WM may have flexibility so as to be deformed depending on folding or bending of the display device DD.

Referring to FIG. 3, the window module WM may include a flat region FA and the curved region RA. A region of a front surface WFS of the window module WM that is parallel to the first direction DR1 and the second direction DR2 and is substantially flat may be defined as the flat region FA. A region of the front surface WFS of the window module WM that includes a curved surface may be defined as the curved region RA. The curved region RA may be adjacent to the flat region FA and may be disposed around the flat region FA. The curved region RA may surround the flat region FA.

The flat region FA of the window module WM may correspond to the first display region DA1 (refer to, e.g., FIG. 1A) of the display device DD, and the curved region RA of the window module WM may correspond to the second display region DA2 (refer to, e.g., FIG. 1A) of the display device DD.

The flat region FA of the window module WM may overlap the active region AA of the display module DM in a third direction DR3. The curved region RA of the window module WM may overlap the peripheral region NAA of the display module DM in the third direction DR3 and may not overlap the active region AA of the display module DM in a third direction DR3. In some embodiments, as illustrated in FIGS. 4A and 4B, a portion of the curved region RA of the window module WM may overlap the active region AA of the display module DM in the third direction DR3.

The flat region FA and the curved region RA of the window module DM may be optically transparent. For example, the flat region FA and the curved region RA may have a visible light transmittance of about 90% or more.

The window module WM may include the window. The window may include a glass substrate or a synthetic resin film. The window may have a multi-layer structure or a single-layer structure. The window module WM may further include a window protection layer disposed on the window. The window protection layer may include a flexible plastic material such as polyimide or polyethylene terephthalate. In some embodiments, the window module WM may further include an adhesive layer disposed between the window and the window protection layer.

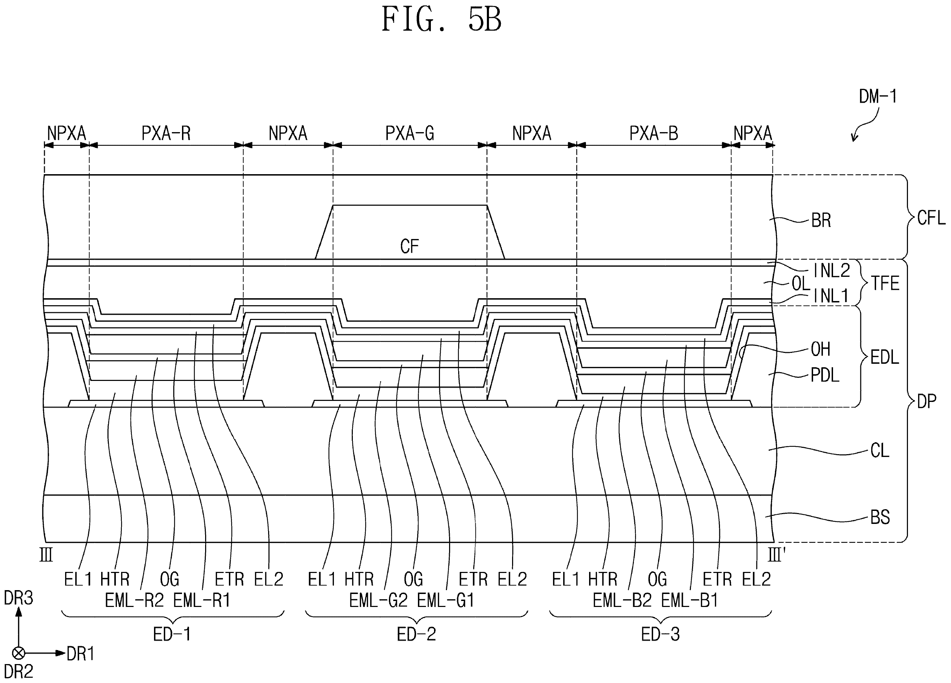

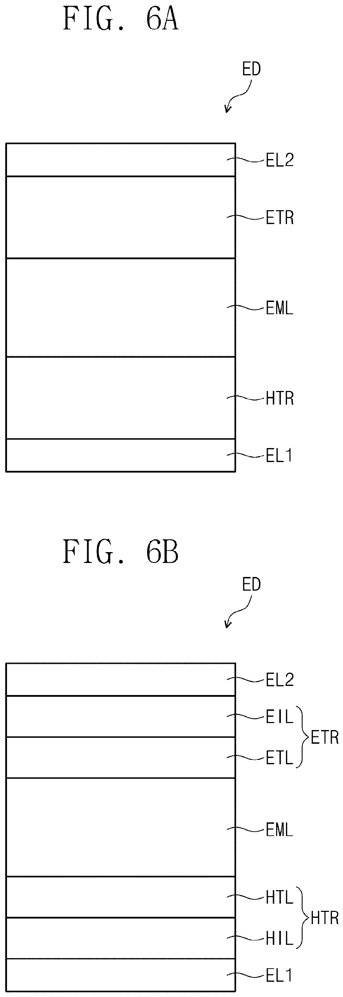

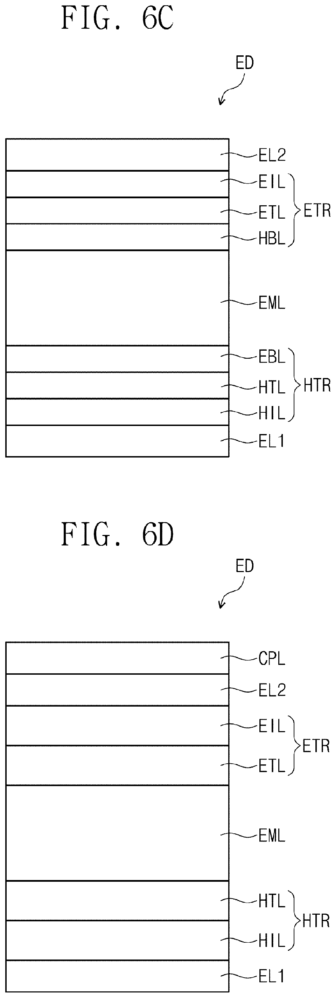

FIGS. 5A and 5B are cross-sectional views of portions of display modules DM and DM-1 according to some embodiments of the present invention. FIGS. 6A to 6D are cross-sectional views of light emitting elements according to some embodiments of the present invention.

FIGS. 5A and 5B illustrate sections taken along line III-III' of FIG. 3. FIGS. 6A to 6D illustrate some embodiments of light emitting elements ED-1, ED-2, and ED-3 of the display module DM of FIG. 5A.

Referring to FIG. 5A, the display module DM may include non-light emitting regions NPXA and the light emitting regions PXA-R, PXA-G, and PXA-B. The light emitting regions PXA-R, PXA-G, and PXA-B may be regions from which light generated by the light emitting elements ED-1, ED-2, and ED-3 is emitted. The light emitting regions PXA-R, PXA-G, and PXA-B may be spaced apart from each other on the plane (e.g., in a plan view).

The light emitting regions PXA-R, PXA-G, and PXA-B may be regions separated by a pixel defining layer PDL. The non-light emitting regions NPXA may be regions between the adjacent light emitting regions PXA-R, PXA-G, and PXA-B and may be regions corresponding to the pixel defining layer PDL. In some embodiments, in this specification, the light emitting regions PXA-R, PXA-G, and PXA-B may correspond to the pixels (refer to, e.g., FIG. 3), respectively. The pixel defining layer PDL may separate the light emitting elements ED-1, ED-2, and ED-3. Light emitting layers EML-R, EML-G, and EML-B of the light emitting elements ED-1, ED-2, and ED-3 may be disposed in openings OH defined in the pixel defining layer PDL and may be separated from one another.

The light emitting regions PXA-R, PXA-G, and PXA-B may be divided into a plurality of groups depending on the colors of light generated by the light emitting elements ED-1, ED-2, and ED-3. FIG. 5A illustrates three light emitting regions PXA-R, PXA-G, and PXA-B that are configured to emit red light, green light, and blue light, respectively. For example, the display module DM may include the red light emitting region PXA-R, the green light emitting region PXA-G, and the blue light emitting region PXA-B separated from one another.

In the display module DM, the plurality of light emitting elements ED-1, ED-2, and ED-3 may be configured to emit light in different wavelength ranges. For example, in some embodiments, the display module DM may include the first light emitting element ED-1 that is configured to emit red light, the second light emitting element ED-2 that is configured to emit green light, and the third light emitting element ED-3 that is configured to emit blue light. For example, the red light emitting region PXA-R, the green light emitting region PXA-G, and the blue light emitting region PXA-B of the display module DM may correspond to the first color light emitting element ED-1, the second color light emitting element ED-2, and the third color light emitting element ED-3, respectively.

However, embodiments of the present invention are not limited thereto, and the first to third color light emitting elements ED-1, ED-2, and ED-3 may be configured to emit light in the same or in substantially the same wavelength range, or at least one of the first to third color light emitting elements ED-1, ED-2, and ED-3 may be configured to emit light in a different wavelength range. For example, all of the first to third color light emitting elements ED-1, ED-2, and ED-3 may be configured to emit blue light.

The light emitting element layer EDL may include first electrodes EL1, a second electrode EL2, and the light emitting layers EML-R, EML-G, and EML-B disposed between the first electrodes EL1 and the second electrode EL2. The light emitting element layer EDL may include the pixel defining layer PDL disposed between the light emitting regions PXA-R, PXA-G, and PXA-B to define the light emitting regions PXA-R, PXA-G, and PXA-B. The light emitting element layer EDL may further include a hole transport region HTR disposed between the first electrodes EL1 and the light emitting layers EML-R, EML-G, and EML-B. The light emitting element layer EDL may further include an electron transport region ETR disposed between the second electrode EL2 and the light emitting layers EML-R, EML-G, and EML-B.

FIG. 5A illustrates some embodiments in which the light emitting layers EML-R, EML-G, and EML-B of the light emitting elements ED-1, ED-2, and ED-3 are disposed in the openings OH defined in the pixel defining layer PDL and the hole transport region HTR, the electron transport region ETR, and the second electrode EL2 are provided as common layers in the light emitting elements ED-1, ED-2, and ED-3. However, embodiments of the present invention are not limited thereto, and unlike those illustrated in FIG. 5A, in some embodiments, the hole transport region HTR and the electron transport region ETR may be subjected to patterning and provided inside the openings OH defined in the pixel defining layer PDL. For example, in some embodiments, the hole transport region HTR, the light emitting layers EML-R, EML-G, and EML-B, and the electron transport region ETR of the light emitting elements ED-1, ED-2, and ED-3 may be subjected to patterning by an ink-jet printing method.

The first electrodes EL1 may be disposed on the circuit layer CL. The first electrodes EL1 have conductivity (e.g., may be a conductor). The first electrodes EL1 may be formed of a metallic material, a metal alloy, a conductive compound, or the like. The first electrodes EL1 may be anodes or cathodes. However, embodiments of the present invention are not limited thereto. Furthermore, the first electrodes EL1 may be pixel electrodes. The first electrodes EL1 may be transmissive electrodes, transflective electrodes, or reflective electrodes. The first electrodes EL1 may include at least one selected from among the group consisting of Ag, Mg, Cu, Al, Pt, Pd, Au, Ni, Nd, Ir, Cr, Li, Ca, LiF, Mo, Ti, W, In, Sn, and Zn, a compound of two or more elements selected from among the group, a mixture of two or more elements selected from among the group, or oxide thereof.

When the first electrodes EL1 are transmissive electrodes, the first electrodes EL1 may include transparent metal oxide, for example, indium tin oxide (ITO), indium zinc oxide (IZO), zinc oxide (ZnO), indium tin zinc oxide (ITZO), or the like. When the first electrodes EL1 are transflective electrodes or reflective electrodes, the first electrodes EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or mixture thereof (e.g., a mixture of Ag and Mg). In some embodiments, the first electrodes EL1 may have a multi-layer structure including a reflective film or a transflective film formed of the aforementioned materials and a transparent conductive film formed of indium tin oxide (ITO), indium zinc oxide (IZO), zinc oxide (ZnO), indium tin zinc oxide (ITZO), or the like. For example, the first electrodes EL1 may have a three-layer structure of ITO/Ag/ITO, but are not limited thereto. Furthermore, embodiments of the present invention are not limited thereto, and the first electrodes EL1 may include the aforementioned metallic materials, a combination of two or more metallic materials selected from among the aforementioned metallic materials, or oxides of the aforementioned metallic materials. The first electrodes EL1 may have a thickness of about 70 nm (700Å) to about 1000 nm (10000Å). For example, the first electrodes EL1 may have a thickness of about 100 nm (1000Å) to about 200 nm (2000Å).

The hole transport region HTR is provided on the first electrodes EL1. Referring to FIG. 6B, the hole transport region HTR may include a hole injection layer HIL and a hole transport layer HTL. Referring to FIG. 6C, the hole transport region HTR may further include an electron blocking layer EBL.

The hole transport region HTR may have a single-layer structure formed of a single material, a single-layer structure formed of a plurality of different materials, or a multi-layer structure having a plurality of layers formed of a plurality of different materials. For example, the hole transport region HTR may have a single-layer structure of the hole injection layer HIL or the hole transport layer HTL, or may have a single-layer structure formed of a hole injection material or a hole transport material. In some embodiments, the hole transport region HTR may have a single-layer structure formed of a plurality of different materials, or may have a multi-layer structure of the hole injection layer HIL/the hole transport layer HTL sequentially stacked on the first electrodes EL1, a multi-layer structure of the hole injection layer HIL/the hole transport layer HTL/a buffer layer sequentially stacked on the first electrodes EL1, a multi-layer structure of the hole injection layer HIL/a buffer layer sequentially stacked on the first electrodes EL1, a multi-layer structure of the hole transport layer HTL/a buffer layer sequentially stacked on the first electrodes EL1, or a multi-layer structure of the hole injection layer HIL/the hole transport layer HTL/the electron blocking layer EBL sequentially stacked on the first electrodes EL1. However, embodiments of the present invention are not limited thereto.

The hole transport region HTR may be formed by using one or more suitable methods such as a vacuum deposition method, a spin coating method, a cast method, a Langmuir-Blodgett (LB) method, an ink-jet printing method, a laser printing method, a laser induced thermal imaging (LITI) method, and the like.

The hole transport region HTR may have a refractive index of about 1.8 to about 2.0. Accordingly, there is a small difference in refractive index between the hole transport region HTR and a light emitting layer EML adjacent thereto, and thus refraction or reflection due to the refractive-index difference at the interface between the hole transport region HTR and the light emitting layer EML may be reduced. As refraction or reflection is reduced at the interface between the layers, resonance that is likely to occur due to this may be prevented or reduced.

The thickness of the hole transport region HTR may range from about 10 nm (100 Å) to about 1000 nm (10000 Å), for example, from about 10 nm (100 Å) to about 500 nm (5000 Å). When the hole transport region HTR includes the hole injection layer HIL, the thickness of the hole injection layer HIL may range, for example, from about 3 nm (30 Å) to about 100 nm (1000 Å). When the hole transport region HTR includes the hole transport layer HTL, the thickness of the hole transport layer HTL may range from about 3 nm (30 Å) to about 100 nm (1000 Å). For example, when the hole transport region HTR includes the electron blocking layer EBL, the thickness of the electron blocking layer EBL may range from about 1 nm (10 Å) to about 100 nm (1000 Å). When the thicknesses of the hole transport region HTR, the hole injection layer HIL, the hole transport layer HTL, and the electron blocking layer EBL satisfy the above-described ranges, satisfying hole transport characteristics may be obtained without a substantial increase in drive voltage.

The light emitting layer EML is disposed on the hole transport region HTR. For example, as illustrated in FIG. 5A, the first color light emitting layer EML-R, the second color light emitting layer EML-G, and the third color light emitting layer EML-B may be provided for the first color light emitting element ED-1, the second color light emitting element ED-2, and the third color light emitting element ED-3, respectively. The first color light emitting layer EML-R may be configured to emit red light, the second color light emitting layer EML-G may be configured to emit green light, and the third color light emitting layer EML-B may be configured to emit blue light.

The light emitting layer EML may have a refractive index of about 1.7 to about 1.95. When the light emitting layer EML has a refractive index in the above-described range, there is a small difference in refractive index between the hole transport region HTR and the electron transport region ETR that are adjacent to the light emitting layer EML, and thus resonance may be further alleviated.

The light emitting layer EML may have, for example, a thickness of about 10 nm (100 Å) to about 100 nm (1000 Å) or a thickness of about 10 nm (100 Å) to about 50 nm (500 Å). The light emitting layer EML may have a single-layer structure formed of a single material, a single-layer structure formed of a plurality of different materials, or a multi-layer structure having a plurality of layers formed of a plurality of different materials.

Referring to FIG. 5B, the display module DM-1 according to some embodiments may include light emitting elements ED-1, ED-2, and ED-3 in each of which two light emitting layers are stacked. The display module DM-1 in the embodiment illustrated in FIG. 5B differs from the display module DM in the embodiment illustrated in FIG. 5A in that each of the first to third color light emitting elements ED-1, ED-2, and ED-3 includes the two light emitting layers stacked in the thickness direction. The two light emitting layers in each of the first to third color light emitting elements ED-1, ED-2, and ED-3 may be configured to emit light in the same or in substantially the same wavelength range.

The first color light emitting element ED-1 may include a first red light emitting layer EML-R1 and a second red light emitting layer EML-R2. The second color light emitting element ED-2 may include a first green light emitting layer EML-G1 and a second green light emitting layer EML-G2. The third color light emitting element ED-3 may include a first blue light emitting layer EML-B1 and a second blue light emitting layer EML-B2.

A light-emission assisting layer OG may be disposed between the first red light emitting layer EML-R1 and the second red light emitting layer EML-R2, between the first green light emitting layer EML-G1 and the second green light emitting layer EML-G2, and between the first blue light emitting layer EML-B1 and the second blue light emitting layer EML-B2. The light-emission assisting layer OG may include a single layer or multiple layers. The light-emission assisting layer OG may include a charge generation layer. More particularly, the light-emission assisting layer OG may include an electron transport region, a charge generation layer, and a hole transport region sequentially stacked one above another. The light-emission assisting layer OG may be provided as a common layer for the first to third light emitting elements ED-1, ED-2, and ED-3. However, embodiments of the present invention are not limited thereto, and the light-emission assisting layer OG may be subjected to patterning and provided in openings OH defined in a pixel defining layer PDL.

The first red light emitting layer EML-R1, the first green light emitting layer EML-G1, and the first blue light emitting layer EML-B1 may be disposed between an electron transport region ETR and the light-emission assisting layer OG. The second red light emitting layer EML-R2, the second green light emitting layer EML-G2, and the second blue light emitting layer EML-B2 may be disposed between the light-emission assisting layer OG and a hole transport region HTR.

For example, the first color light emitting element ED-1 may include a first electrode EL1, the hole transport region HTR, the second red light emitting layer EML-R2, the light-emission assisting layer OG, the first red light emitting layer EML-R1, the electron transport region ETR, and a second electrode EL2 sequentially stacked one above another. The second color light emitting element ED-2 may include a first electrode EL1, the hole transport region HTR, the second green light emitting layer EML-G2, the light-emission assisting layer OG, the first green light emitting layer EML-G1, the electron transport region ETR, and a second electrode EL2 sequentially stacked one above another. The third color light emitting element ED-3 may include a first electrode EL1, the hole transport region HTR, the second blue light emitting layer EML-B2, the light-emission assisting layer OG, the first blue light emitting layer EML-B1, the electron transport region ETR, and a second electrode EL2 sequentially stacked one above another.

Referring to FIG. 6A, the electron transport region ETR may be disposed on the light emitting layer EML. Referring to FIG. 6B, the electron transport region ETR may include an electron injection layer EIL and an electron transport layer ETL. Referring to FIG. 6C, the electron transport region ETR may further include a hole blocking layer HBL.

Referring to FIGS. 6A to 6D, the electron transport region ETR may have a single-layer structure formed of a single material, a single-layer structure formed of a plurality of different materials, or a multi-layer structure having a plurality of layers formed of a plurality of different materials. For example, the electron transport region ETR may have a single-layer structure of the electron injection layer EIL or the electron transport layer ETL, or may have a single-layer structure formed of an electron injection material or an electron transport material. In some embodiments, the electron transport region ETR may have a single-layer structure formed of a plurality of different materials, or may have a multi-layer structure of the electron transport layer ETL/the electron injection layer EIL sequentially stacked on the light emission layer EML or a multi-layer structure of the hole blocking layer HBL/the electron transport layer ETL/the electron injection layer EIL sequentially stacked on the light emission layer EML. However, embodiments of the present invention are not limited thereto.

The electron transport region ETR may be formed by using one or more suitable methods such as a vacuum deposition method, a spin coating method, a cast method, a Langmuir-Blodgett (LB) method, an ink-jet printing method, a laser printing method, a laser induced thermal imaging (LITI) method, and the like.

The electron transport region ETR may have a refractive index of about 1.8 to about 2.0. Accordingly, there is a small difference in refractive index between the electron transport region ETR and the light emitting layer EML adjacent thereto, and thus resonance due to refraction or reflection at the interface between the layers may be further alleviated.

The thickness of the electron transport region ERT may range, for example, from about 30 nm (300 Å) to about 200 nm (2000 Å). When the electron transport region ETR includes the electron transport layer ETL, the thickness of the electron transport layer ETL may range from about 10 nm (100 Å) to about 100 nm (1000 Å), for example, from about 15 nm (150 Å) to about 50 nm (500 Å). When the thickness of the electron transport layer ETL satisfies the above-described range, satisfying electron transport characteristics may be obtained without a substantial increase in drive voltage. When the electron transport region ETR includes the electron injection layer EIL, the thickness of the electron injection layer EIL may range from about 0,1 nm (1 Å) to about 10 nm (100 Å), for example, from about 0,3 nm (3 Å) to about 9 nm (90 Å). When the thickness of the electron injection layer EIL satisfies the above-described range, satisfying electron injection characteristics may be obtained without a substantial increase in drive voltage.

The second electrode EL2 is provided on the electron transport region ETR. The second electrode EL2 may be a common electrode. The second electrode EL2 may be a cathode or an anode, but embodiments of the present invention are not limited thereto. For example, when the first electrodes EL1 are anodes, the second electrode EL2 may be a cathode, and when the first electrodes EL1 are cathodes, the second electrode EL2 may be an anode.

The second electrode EL2 may be a transmissive electrode. The second electrode EL2 may include transparent conductive metal oxide. For example, the second electrode EL2 may be formed of indium tin oxide (ITO), indium zinc oxide (IZO), zinc oxide (ZnO), indium tin zinc oxide (ITZO), or the like. Accordingly, light emitted from the light emitting layer EML may be emitted without resonance that is likely to occur due to reflection when the second electrode EL1 is a transflective or reflective electrode. The second electrode EL2 may have a thickness of about 5 nm (50 Å) to about 100 nm (1000 Å).

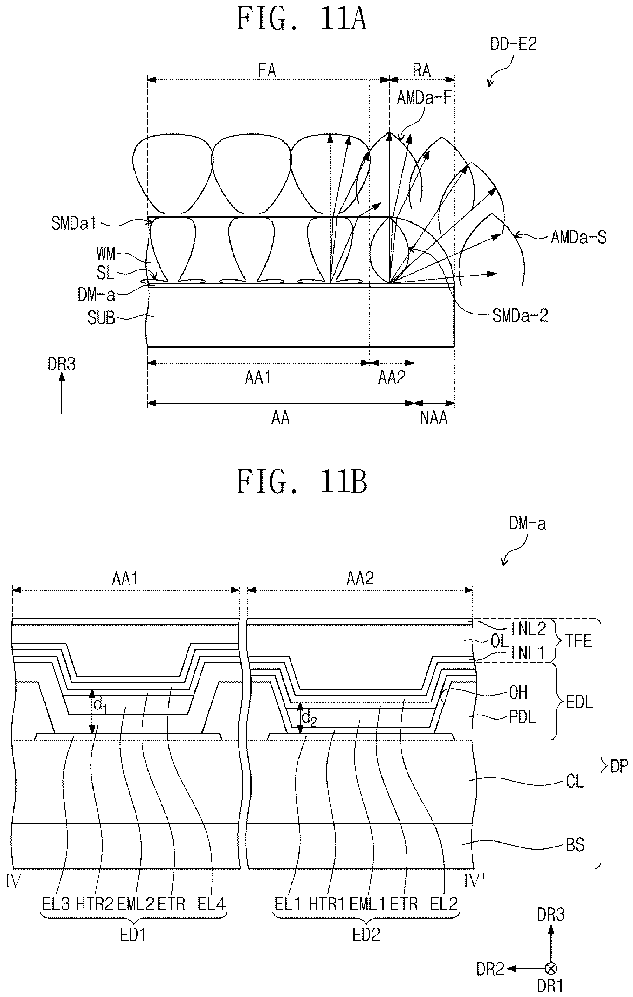

In some embodiments, the second electrode EL2 may not be a transmissive electrode in a region where a structure for alleviating resonance is not applied as illustrated in FIG. 11A to be described below. For example, the second electrode EL2 may include at least one selected from among the group consisting of Ag, Mg, Cu, Al, Pt, Pd, Au, Ni, Nd, Ir, Cr, Li, Ca, LiF, Mo, Ti, W, In, Sn, and Zn, a compound of two or more elements selected from among the group, a mixture of two or more elements selected from among the group, or oxide thereof.

In some embodiments, the distances d_{R1}, d_{G1}, and d_{B1} (refer to, e.g., FIG. 5A) between the first electrodes EL1 and the second electrode EL2 correspond to primary resonance distances for light emitted from the light emitting layers EML-R, EML-G, and EML-B. For example, the distances between the first electrodes EL1 and the second electrode EL2 may range from among 70 nm (700 Å) to about 130 nm (1300 Å). The distances between the first electrodes EL1 and the second electrode EL2 may be changed by adjusting the distances between the first electrodes EL1 and the light emitting layers EML-R, EML-G, and EML-B. For example, the distances between the first electrodes EL1 and the second electrode EL2 may be changed by adjusting the thickness of the hole transport region HTR between the first electrodes EL1 and the light emitting layers EML-R, EML-G, and EML-B. The thickness of the hole transport region HTR may be adjusted by thickening one layer or by forming a multi-layer structure by adding layers for compensating for the thickness. For example, the distances between the first electrodes EL1 and the light emitting layers EML-R, EML-G, and EML-B may range from about 10 nm (100 Å) to about 40 nm (400 Å).

For example, referring to FIG. 5A, the distance d_{R1} between the first electrode EL1 and the second electrode EL2 in the first color light emitting element ED-1 may correspond to a primary resonance distance of first color light emitted from the first color light emitting layer EML-R, the distance d_{G1} between the first electrode EL1 and the second electrode EL2 in the second color light emitting element ED-2 may correspond to a primary resonance distance of second color light emitted from the second color light emitting layer EML-G, and the distance d_{B1} between the first electrode EL1 and the second electrode EL2 in the third color light emitting element ED-3 may correspond to a primary resonance distance of third color light emitted from the third color light emitting layer EML-B. For example, the distance d_{R1} between the first electrode EL1 and the second electrode EL2 in the first color light emitting element ED-1 may range from about 110 nm (1100 Å) to about 130 nm (1300 Å), the distance d_{G1} between the first electrode EL1 and the second electrode EL2 in the second color light emitting element ED-2 may range from about 90 nm (900 Å) to about 110 nm (1100 Å), and the distance d_{B1} between the first electrode EL1 and the second electrode EL2 in the third color light emitting element ED-3 may range from about 70 nm (700 Å) to about 90 nm (900 Å). In some embodiments, the distance d_{R2} between the first electrode EL1 and the first color light emitting layer EML-R in the first color light emitting element ED-1 may range from about 30 nm (300 Å) to about 40 nm (400 Å), the distance d_{G2} between the first electrode EL1 and the second color light emitting layer EML-G in the second color light emitting element ED-2 may range from about 15 nm (150 Å) to about 25 nm (250 Å), and the distance d_{B2} between the first electrode EL1 and the third color light emitting layer EML-B in the third color light emitting element ED-3 may range from about 10 nm (100 Å) to about 20 nm (200 Å).

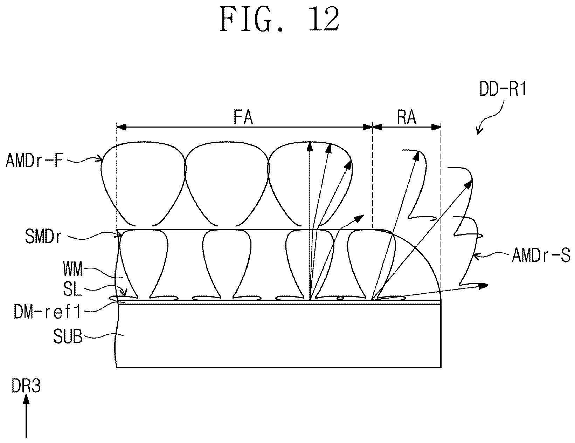

Because the distances d_{R1}, d_{G1}, and d_{B1} between the first electrodes EL1 and the second electrode EL2 and the distances d_{R2}, d_{G2}, and d_{B2} between the first electrodes EL1 and the first to third color light emitting layers EML-R, EML-G, and EML-B in the first to third color light emitting elements ED-1, ED-2, and ED-3 are within the above-described ranges, side lobes SL (refer to, e.g., FIG. 12) that are likely to occur when the distances between the first electrodes EL1 and the second electrode EL2 correspond to secondary resonance distances may not occur. Here, the side lobes are patterns radiated in directions other than the direction of main light among light radiation patterns. In contrast, when the side lobes occur, luminance may not be uniform on the outer surface of the display device DD (refer to, e.g., FIG. 3) including the curved region RA (refer to, e.g., FIG. 3), and light leakage may occur.

A capping layer CPL (refer to, e.g., FIG. 6B) may be additionally disposed on a second electrode EL2 of a light emitting element ED of some embodiments. The capping layer CPL may have a single-layer structure or a multi-layer structure. In some embodiments, the capping layer CPL may be an organic layer or an inorganic layer. For example, when the capping layer CPL includes an inorganic material, the inorganic material may include an alkali metal compound (e.g., LiF), an alkaline earth metal compound (e.g., MgF₂), SiON, SiNₓ, SiO_{y}, or the like. The capping layer CPL may have a refractive index of about 1.6 or more. For example, the capping layer CPL may have a refractive index of about 1.6 or more for light having a wavelength range of about 550 nm to about 660 nm.

Referring to FIGS. 5A and 5B, the encapsulation layer TFE may be disposed on the second electrode EL2 and may fill the openings OH. The encapsulation layer TFE may cover the light emitting elements ED-1, ED-2, and ED-3. The encapsulation layer TFE may seal the light emitting element layer EDL. The encapsulation layer TFE may be a thin film encapsulation layer. The encapsulation layer TFE may include one layer or a plurality of layers stacked one above another. The encapsulation layer TFE includes at least one insulating layer. The encapsulation layer TFE according to some embodiments may include at least one inorganic film (hereinafter, referred to as the inorganic encapsulation film). In some embodiments, the encapsulation layer TFE may include at least one organic film (hereinafter, referred to as the organic encapsulation film) and at least one inorganic encapsulation film. The inorganic encapsulation film may include a first inorganic layer INL1 and a second inorganic layer INL2 of FIGS. 5A and 5B, and the organic encapsulation film may include an organic layer OL of FIGS. 5A and 5B.

The inorganic encapsulation film protects the light emitting element layer EDL from moisture/oxygen, and the organic encapsulation film OL protects the light emitting element layer EDL from foreign matter such as dust particles. The inorganic encapsulation film may include silicon nitride, silicon oxy nitride, silicon oxide, titanium oxide, aluminum oxide, or the like, but is not particularly limited thereto. The organic encapsulation film may include an acrylic compound, an epoxy compound, or the like. The organic encapsulation film may include an organic material capable of photopolymerization, but is not particularly limited.

Referring to FIGS. 5A and 5B, the encapsulation layer TFE of some embodiments may include the first inorganic layer INL1 disposed on the light emitting element layer EDL, the organic layer OL disposed on the first inorganic layer INL1, and the second inorganic layer INL2 disposed on the organic layer OL.

In some embodiments, the first inorganic layer INL1 may be directly disposed on the light emitting element layer EDL. For example, the first inorganic layer INL1 may be directly disposed on the second electrode EL2. Alternatively, when the capping layer CPL is disposed on the second electrode EL2, the first inorganic layer INL1 may be directly disposed on the capping layer CPL. The first inorganic layer INL1 disposed on the second electrode EL2 may protect the light emitting element layer EDL from moisture/oxygen.

The first inorganic layer INL1 of some embodiments has a single-layer structure. Accordingly, when the first inorganic layer INL1 has a multi-layer structure, resonance due to reflection/refraction at the interfaces between layers may be alleviated.

The first inorganic layer INL1 may have a refractive index of about 1.8 to about 2.0. When the refractive index of the first inorganic layer INL1 is within the range, resonance may be further alleviated.

The color filter layer CFL may be disposed on the display panel DP. The color filter layer CFL may include a color filter CF and a barrier layer BR.

Referring to FIGS. 5A and 5B, the color filter CF may overlap the second color light emitting element ED-2 in the third direction DR3 and may not overlap the first color light emitting element ED-1 and the third color light emitting element ED-3 in the third direction DR3. The color filter CF may be a green filter that is configured to transmit green light. The color filter CF may include a photosensitive polymer resin and a pigment or dye. The color filter CF may include a green pigment or dye. The color filter CF overlapping the second color light emitting element ED-2 may improve (e.g., increase) the color gamut of the second color light. A light emitting element having a primary resonance structure as in some embodiments according to the present invention may prevent light in a long wavelength region outside the green light region from being transmitted, thereby improving the color gamut.

The barrier layer BR may serve to prevent infiltration of moisture/oxygen. The barrier layer BR may include at least one inorganic layer. For example, the barrier layer BR may include an inorganic material. For example, the barrier layer BR may include silicon nitride, aluminum nitride, zirconium nitride, titanium nitride, hafnium nitride, tantalum nitride, silicon oxide, aluminum oxide, titanium oxide, tin oxide, cerium oxide, or silicon oxy nitride, or the like, or may include a metal thin film with secured light transmittance. In some embodiments, the barrier layer BR may further include an organic film. The barrier layer BR may include a single layer or a plurality of layers.

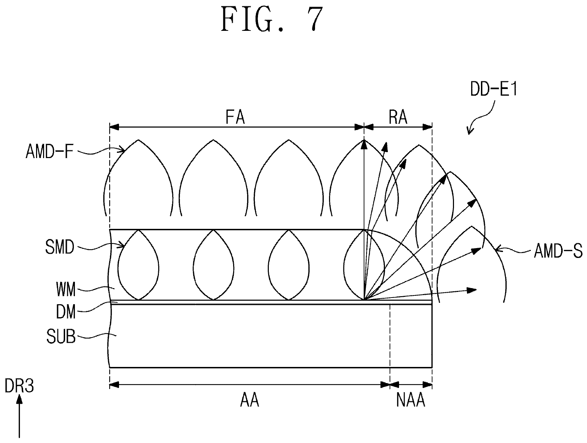

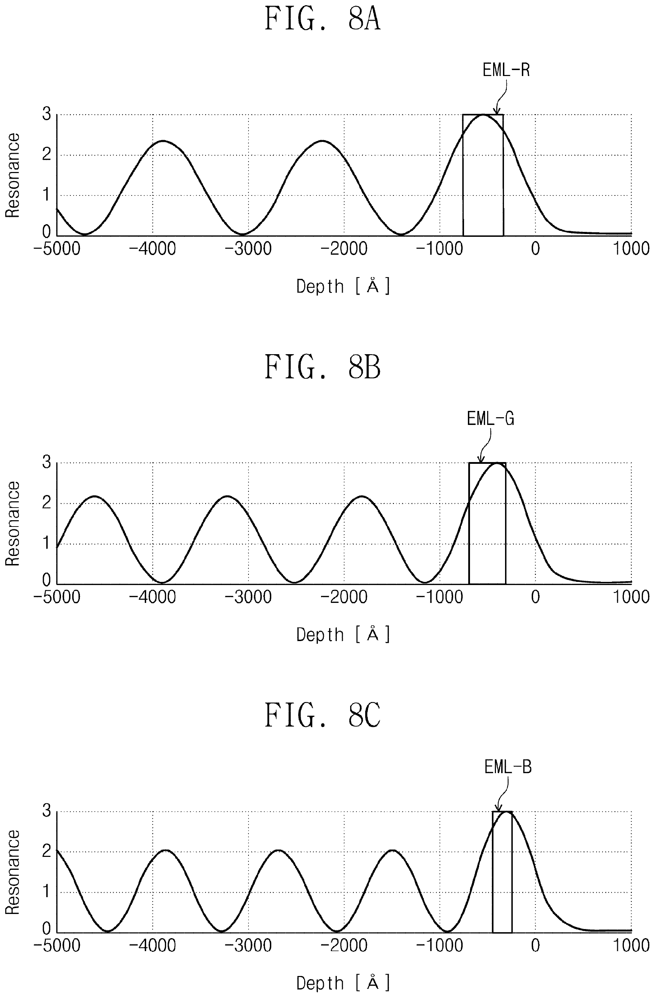

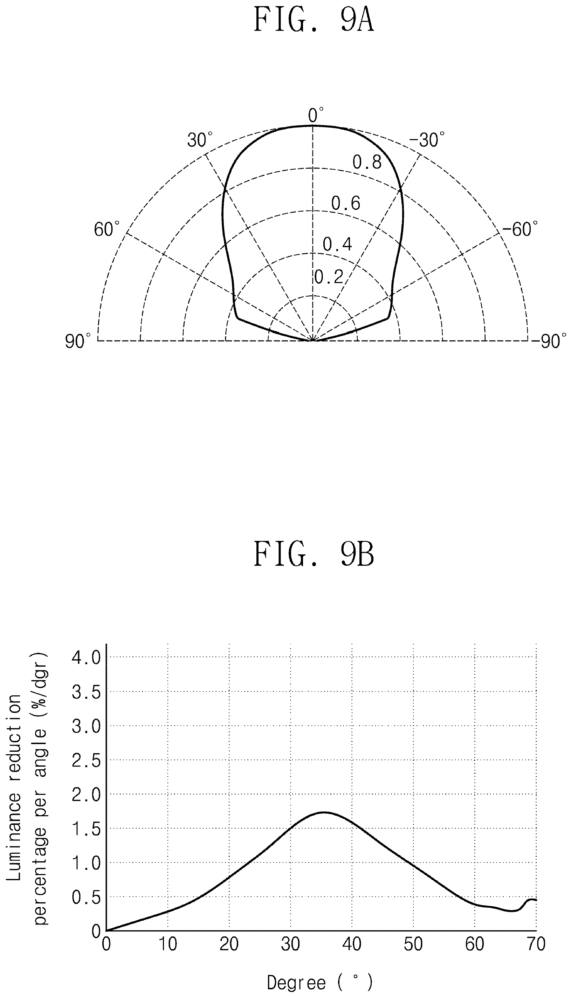

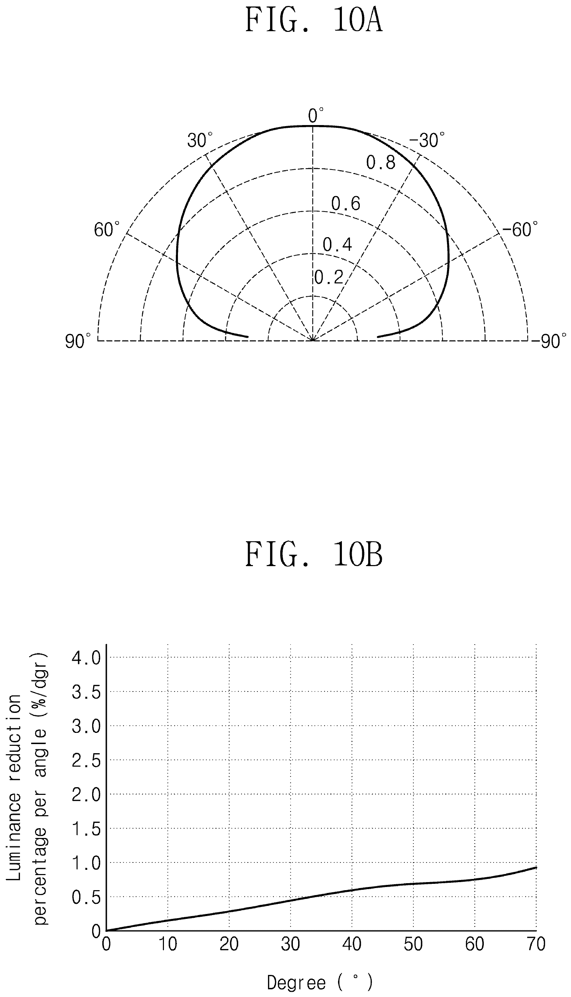

FIG. 7 is a schematic view illustrating optical characteristics in a portion of a display device DD-E1 according to some embodiments of the present invention. FIGS. 8A to 8C are resonance graphs of light emitted from light emitting elements according to some embodiments of the present invention. FIG. 9A is a graph of luminance distribution of a substrate mode SMD according to some embodiments of the present invention. FIG. 9B is a graph of luminance reduction percentage per angle of the substrate mode SMD according to some embodiments of the present invention. FIG. 10A is a graph of luminance distribution of an air mode AMD-F and AMD-S according to some embodiments of the present invention. FIG. 10B is a graph of luminance reduction percentage per angle of the air mode AMD-F and AMD-S according to some embodiments of the present invention.

FIG. 7 schematically illustrates luminance distribution of the display device DD-E1 including the display module DM of FIG. 5A. FIG. 7 illustrates an example that the display module DM and the window module WM are disposed on a substrate SUB for supporting the display module DM and the window module WM. The display module DM includes the light emitting elements ED-1, ED-2, and ED-3 described above with reference to FIG. 5A.

Each of the light emitting elements used in the evaluation of FIGS. 7 to 10B has a structure in which a first electrode, a hole transport region, a light emitting layer, an electron transport region, a second electrode, and a capping layer are sequentially stacked one above another, and the thicknesses thereof are listed in Table 1. In some embodiments, a single-layer structure of SiNₓ is applied as a first inorganic layer disposed on the capping layers of the light emitting elements. Ag (100 nm (1000 Å))/ITO (7 nm (70 Å)) is used for the first electrodes, and IZO is used for the second electrodes.

**Table 1**

| | Thickness (nm (Å)) | | |
|---|---|---|---|
| Functional layer | Red pixel | Green pixel | Blue pixel |
| Capping layer | 89 (890) | 89 (890) | 89 (890) |
| Second electrode | 66 (660) | 66 (660) | 66 (660) |
| Electron transport region | 43,5 (435) | 43,5 (435) | 43,5 (435) |
| Light emitting layer | 42 (420) | 38 (380) | 19 (190) |
| Hole transport region | 35 (350) | 20 (200) | 15 (150) |
| First electrode | 107 (1070) | 107 (1070) | 107 (1070) |

Referring to FIG. 7, when the display module DM is applied, the radiation form of the substrate mode SMD does not include side lobes. In some embodiments, the radiation form of the air mode AMD-F of light emitted to the front and the radiation form of the air mode AMD-S of light emitted to the side are substantially uniform. For example, light emitted from the display module DM may be uniformly viewed for each of the flat region FA and the curved region RA of the window module WM irrespective of the viewing angle. Here, the substrate mode SMD refers to measuring, within the window module WM, light emitted from the display module DM. The air mode AMD-F and AMD-S refers to measuring light emitted from the display module DM and output to the outside through the window module WM.

FIGS. 8A to 8C are resonance graphs of the display module DM of FIG. 7. FIG. 8A is a resonance graph in the first color pixel PXA-R (refer to, e.g., FIG. 5A), FIG. 8B is a resonance graph in the second color pixel PXA-G (refer to, e.g., FIG. 5A), and FIG. 8C is a resonance graph in the third color pixel PXA-B (refer to, e.g., FIG. 5A). Here, the first color pixel, the second color pixel, and the third color pixel may be referred to as the red pixel, the green pixel, and the blue pixel, respectively. In FIGS. 8A to 8C, the y-axis represents the luminance of light normalized based on 3, and the x-axis represents the depth to the first inorganic layer (-500 nm (-5000 Å)) based on the first electrode (0 nm (0Å)). Referring to FIGS. 8A to 8C, light emitted from the light emitting layers EML-R, EML-G, and EML-B may undergo primary resonance. The positions illustrated by rectangles in FIGS. 8A to 8C indicate the portions where the light emitting layers EML-R, EML-G, and EML-B are located.

FIG. 9A is a graph of luminance distribution of the substrate mode SMD of the display module DM of FIG. 7, and FIG. 9B is a graph of luminance reduction percentage per angle in the substrate mode SMD. In the graph of luminance distribution and the graph of luminance reduction percentage per angle, the direction DR3 from the display module DM toward the window module WM is set to 0°. In some embodiments, the luminance reduction percentage per angle represents the percentage of reduced luminance based on the luminance of light emitted in the direction DR3.

Referring to FIG. 9A, side lobes may not occur as described above with reference to FIG. 7. Referring to FIG. 9B, the luminance reduction percentage per angle may be about 2% / dgr or less (up to about 1.78%).

Because the luminance reduction percentage per angle in the substrate mode SMD is small, the radiation form in the air mode AMD-F and AMD-S may appear as illustrated in FIGS. 10A and 10B, and the luminance reduction percentage per angle may be about 1% / dgr or less.

For example, in the case of the display device to which the display module DM is applied, the luminance reduction percentage per angle of emitted light is very small even when the viewing angle is increased in the direction from the front to the side in the display module DM. Accordingly, in the case of the display device of the embodiment, light emitted from the display module DM may be uniformly viewed for each of the flat region FA and the curved region RA even after passing through the window module WM including the curved region RA.

FIG. 11A is a view illustrating optical characteristics in a portion of a display device DD-E2 according to some embodiments of the present invention. FIG. 11B is a cross-sectional view of a portion of a display module DM-a according to some embodiments of the present invention.

When compared to FIG. 7 to which the display module DM of FIG. 5A is applied, FIG. 11A illustrates some embodiments in which the light emitting elements ED-1, ED-2, and ED-3 described with reference to FIG. 5A are disposed only in a second region AA2. A first light emitting element ED1 that will be described below may be disposed in a first region AA1. FIG. 11B illustrates a portion of a section corresponding to line IV-IV' of FIG. 3.

Referring to FIG. 11A, an active region AA may include the first region AA1 and the second region AA2. The second region AA2 may be disposed outward of the first region AA1. The second region AA2 may surround the first region AA1. In FIG. 11A, the second region AA2 is illustrated as overlapping a flat region FA and a curved region RA of a window module WM in the third direction DR3. However, without being limited thereto, the second region AA2 may overlap the flat region FA and may not overlap the curved region RA in the third direction DR3. In some embodiments, the second region AA2 may not overlap the flat region FA and may overlap the curved region RA in the third direction DR3.

Referring to FIG. 11B, the display module DM-a may include the first region light emitting element ED1 in the first region AA1 and a second region light emitting element ED2 in the second region AA2.

The first region light emitting element ED1 may be referred to as the first light emitting element ED1, and the second region light emitting element ED2 may be referred to as the second light emitting element ED2. The second region light emitting element ED2 may be one of the first to third color light emitting elements ED-1, ED-2, and ED-3 described with reference to FIG. 5A, and the first region light emitting element ED1 will be described below.

The descriptions of the light emitting elements ED-1, ED-2, and ED-3 given above with reference to FIG. 5A may be applied to the second light emitting element ED2. The second light emitting element ED2 includes a first electrode EL1, a second electrode EL2 disposed over the first electrode EL1, and a light emitting layer EML1 disposed between the first electrode EL1 and the second electrode EL2. The light emitting layer EML1 disposed between the first electrode EL1 and the second electrode EL2 may be referred to as the first light emitting layer so as to be distinguished from a light emitting layer EML2 of the first light emitting element ED1. The second electrode EL2 includes transparent conductive metal oxide. The distance d₂ between the first electrode EL1 and the second electrode EL2 is a primary resonance distance for light emitted from the first light emitting layer EML1.

Accordingly, as illustrated in FIG. 11A, when the display module DM-a is applied, unlike the radiation form of a substrate mode SMDa1 of light emitted from the first region AA1, the radiation form of a substrate mode SMDa-2 of light emitted from the second region AA2 may not have side lobes SL. In some embodiments, the radiation form of an air mode AMDa-F of light emitted from the second region AA2 to the front and the radiation form of an air mode AMDa-S of light emitted from the second region AA2 to the side may be substantially uniform. For example, light emitted from the second region AA2 disposed at the outside on the plane of the display module DM-a may be uniformly viewed irrespective of the viewing angle in the curved region RA of the window module WM.

A graph of luminance distribution and a graph of luminance reduction percentage per angle of the substrate mode SMDa-2 of light emitted from the second region AA2 may be the same or substantially the same as the graphs of FIGS. 9A and 9B that are graphs related to FIG. 7. A graph of luminance distribution and a graph of luminance reduction percentage per angle of the air mode AMDa-F and AMDa-S of light emitted from the second region AA2 may be the same or substantially the same as the graphs of FIGS. 10A and 10B that are graphs related to FIG. 7. The luminance reduction percentage per angle within the window module WM of light emitted from the second region AA2 of the display module DM-a may be about 2% / dgr or less based on the luminance of light emitted in a direction parallel to the direction DR3 from the display module DM-a toward the window module WM. The luminance reduction percentage per angle of light emitted from the second region AA2 of the display module DM-a and output through the window module WM may be about 1% / dgr or less based on the luminance of light emitted in a direction parallel to the direction from the display module DM-a toward the window module WM.

For example, in the case of the display device to which the display module DM-a is applied, the luminance reduction percentage per angle of light emitted from the display module DM-a of the second region AA2 disposed at the outside on the plane is very small. Accordingly, in the case of the display device of some embodiments, light emitted from the display module DM-a may be uniformly viewed irrespective of the viewing angle even after passing through the window module WM including the curved region RA.

The first light emitting element ED1 may include a third electrode EL3, a fourth electrode EL4 disposed over the third electrode EL3, and the light emitting layer EML2 disposed between the third electrode EL3 and the fourth electrode EL4. The light emitting layer EML2 disposed between the third electrode EL3 and the fourth electrode EL4 may be referred to as the second light emitting layer so as to be distinguished from the light emitting layer EML1 of the second light emitting element ED2.

The distance d₁ between the third electrode EL3 and the fourth electrode EL4 of the first light emitting element ED1 may be a secondary resonance distance for light emitted from the light emitting layer EML2 of the first light emitting element ED1. For example, the distance d₁ between the third electrode EL3 and the fourth electrode EL4 may range from about 190 nm (1900 Å) to about 310 nm (3100 Å).The distance d₁ between the third electrode EL3 and the fourth electrode EL4 of the first light emitting element ED1 may be greater than the distance d₂ between the first electrode EL1 and the second electrode EL2 of the second light emitting element ED2. The fourth electrode EL4 may include translucent conductive metal oxide.

A particular structure of the first light emitting element ED1 is shown in Table 2. A multi-layer structure of LiF (40 nm (400 Å))/SiNₓ (135 nm (1350 Å))/SiON (1000 nm (10000 Á)) is applied as a first inorganic layer on a capping layer. Ag (100 nm (1000 Å))/ITO (7 nm (70 Å)) is applied as the third electrode, and AgMg is applied as the fourth electrode. In some embodiments, a color filter CF is not applied.

**Table 2**

| | Thickness (nm (Å)) | | |
|---|---|---|---|
| Functional layer | Red pixel | Green pixel | Blue pixel |
| Capping layer | 89 (890) | 89 (890) | 89 (890) |
| Fourth electrode | 9,5 (95) | 9,5 (95) | 9,5 (95) |
| Electron transport region | 43,5 (435) | 43,5 (435) | 43,5 (435) |
| Light emitting layer | 42 (420) | 38 (380) | 19 (190) |
| Hole transport region | 214,5 (2145) | 165 (1650) | 140 (1400) |
| Third electrode | 107 (1070) | 107 (1070) | 107 (1070) |

However, the first light emitting element ED1 is not particularly limited and may be changed as desired in a suitable manner. For example, the fourth electrode may be a transmissive electrode, a transflective electrode, a reflective electrode, or the like. When the second electrode EL2 is a transmissive electrode, the second electrode EL2 may include transparent metal oxide, for example, indium tin oxide (ITO), indium zinc oxide (IZO), zinc oxide (ZnO), indium tin zinc oxide (ITZO), or the like. The second electrode EL2 may have a thickness of about 50 nm (500 Å) to about 80 nm (800 Å). When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (e.g., AgMg, AgYb, or MgAg). In some embodiments, the second electrode EL2 may have a multi-layer structure including a reflective film or a transflective film formed of the aforementioned materials and a transparent conductive film formed of indium tin oxide (ITO), indium zinc oxide (IZO), zinc oxide (ZnO), indium tin zinc oxide (ITZO), or the like. For example, the second electrode EL2 may include the aforementioned metallic materials, a combination of two or more metallic materials selected from among the aforementioned metallic materials, or oxides of the aforementioned metallic materials. Because the second light emitting element ED2 of the second region AA2 disposed outward of the first region AA1 is included, light emitted from the display module DM-a may be uniformly viewed irrespective of the viewing angle from the outside in the display device having the curved region RA.

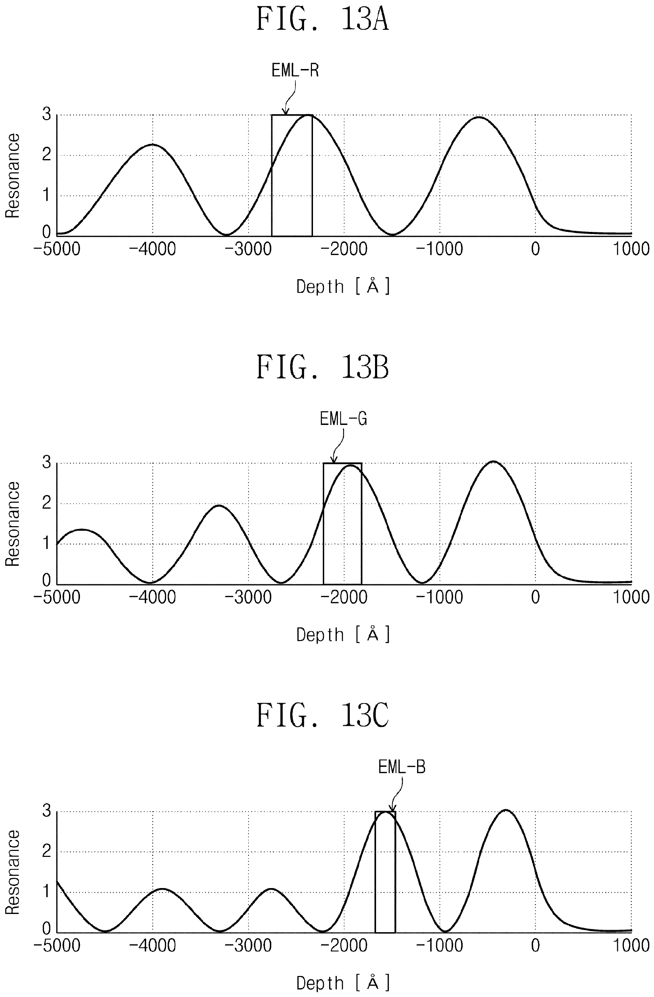

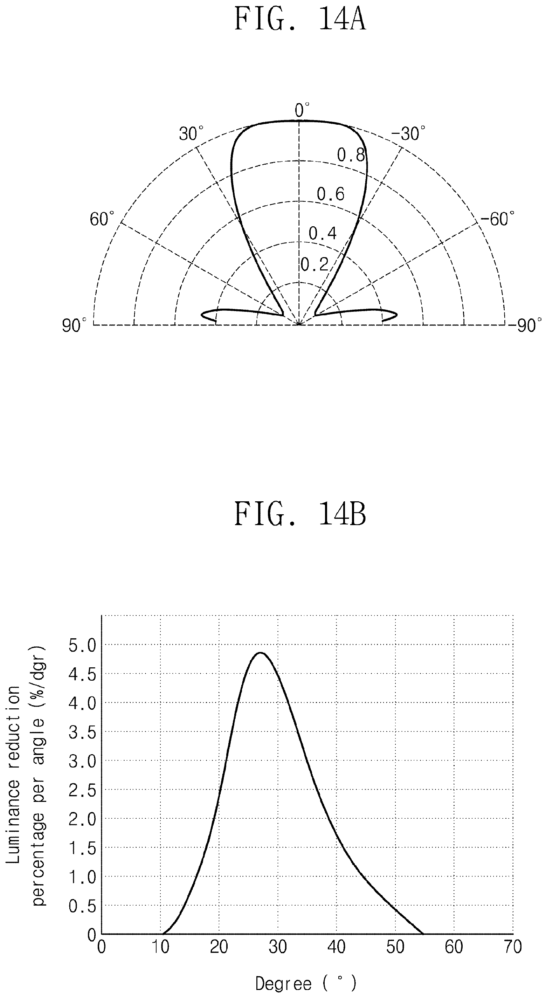

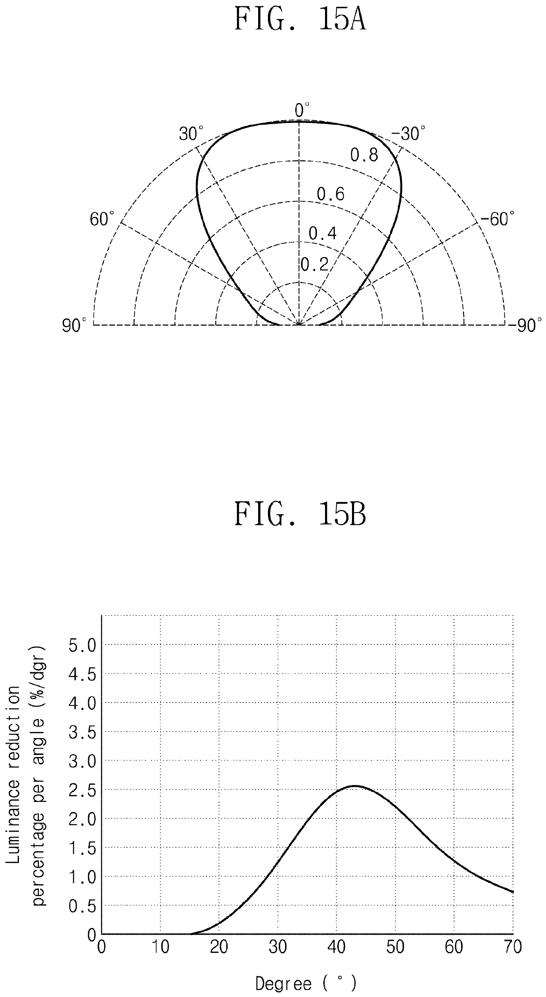

FIG. 12 is a schematic view illustrating optical characteristics in a portion of a display device DD-R1 according to comparative example 1. FIGS. 13A to 13C are resonance graphs of light emitted from light emitting elements according to comparative example 1. FIG. 14A is a graph of luminance distribution of a substrate mode SMDr according to comparative example 1. FIG. 14B is a graph of luminance reduction percentage per angle of the substrate mode SMDr according to comparative example 1. FIG. 15A is a graph of luminance distribution of an air mode AMDr-F according to comparative example 1. FIG. 15B is a graph of luminance reduction percentage per angle of an air mode AMDr-S according to comparative example 1.

FIG. 12 is a schematic view illustrating luminance distribution of the display device to which a display module DM-ref1 of comparative example 1 different from the display module DM according to some embodiments of the present invention is applied. The display module DM-ref1 and a window module WM of comparative example 1 are disposed on a substrate SUB. A particular structure of light emitting elements in the display module DM-ref1 is the same or substantially the same as that in Table 2 described above.

Referring to FIG. 12, when the display module DM-ref1 of comparative example 1 is applied, the radiation form of the substrate mode SMDr includes side lobes SL. In comparative example 1, the radiation form of the air mode AMDr-F of light emitted to the front and the radiation form of the air mode AMDr-S of light emitted to the side are not substantially uniform. For example, light emitted from the display module DM-ref1 of comparative example 1 may not be uniformly viewed depending on angles in a curved region RA of the window module WM, and light leakage may occur.

FIGS. 13A to 13C are resonance graphs of the display module DM-ref1 of FIG. 12. FIG. 13A is a resonance graph in a red pixel, FIG. 13B is a resonance graph in a green pixel, and FIG. 13C is a resonance graph in a blue pixel. In FIGS. 13A to 13C, the y-axis represents the luminance of light normalized based on 3, and the x-axis represents the depth to a first inorganic layer (-500 nm (-5000 Å)) based on a third electrode (0 nm (0 Å)). Referring to FIGS. 13A to 13C, light emitted from light emitting layers may undergo secondary resonance between the third electrode and the fourth electrode.

FIG. 14A is a graph of luminance distribution of the substrate mode SMDr of the display module DM-ref1 of FIG. 12, and FIG. 14B is a graph of luminance reduction percentage per angle of the substrate mode SMDr. The graph of luminance distribution and the graph of luminance reduction percentage per angle are based on the luminance of light emitted in the direction DR3 from the display module DM-ref1 toward the window module WM.

Referring to FIG. 14A, side lobes SL may occur as described above with reference to FIG. 12. Referring to FIG. 14B, the luminance reduction percentage per angle may be up to about 4.9% / dgr. In some embodiments, the luminance reduction percentage may vary depending on the viewing angle.

Accordingly, as illustrated in FIGS. 15A and 15B, the radiation form of the air mode AMDr-F of light emitted to the front may appear, and the luminance reduction percentage per angle may be up to about 2.6% / dgr.

For example, in the case of the display device to which the display module dM-ref1 of comparative example 1 is applied, the luminance reduction percentage per angle of light emitted from the display module DM-ref1 is high. Accordingly, in the case of the display device of comparative example 1, light emitted from the display module DM-ref1 may not be uniformly viewed depending on angles after passing through the window module WM including the curved region RA, and light leakage may occur.

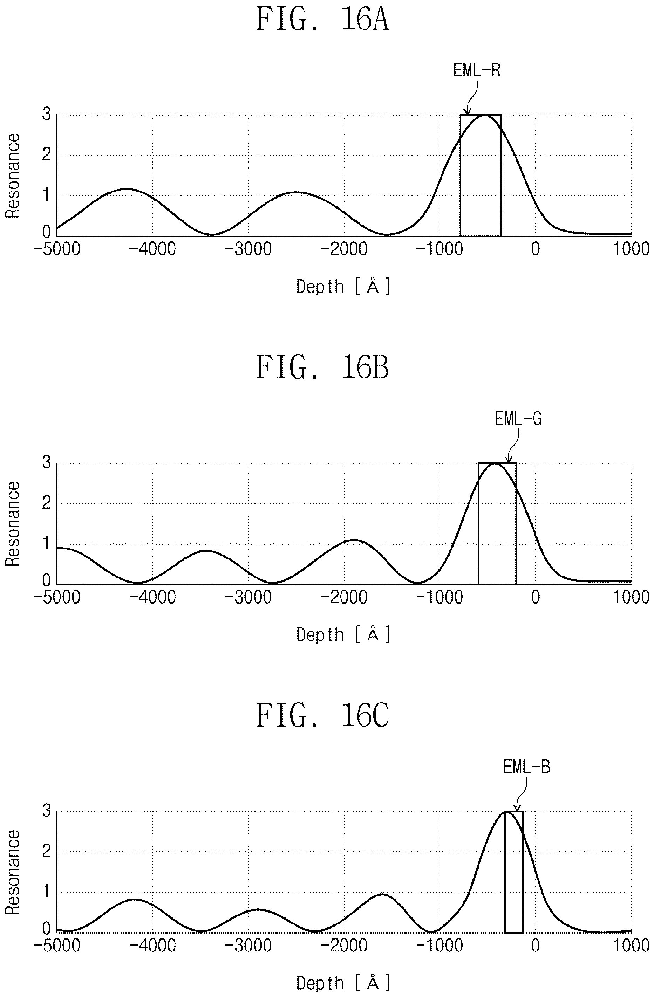

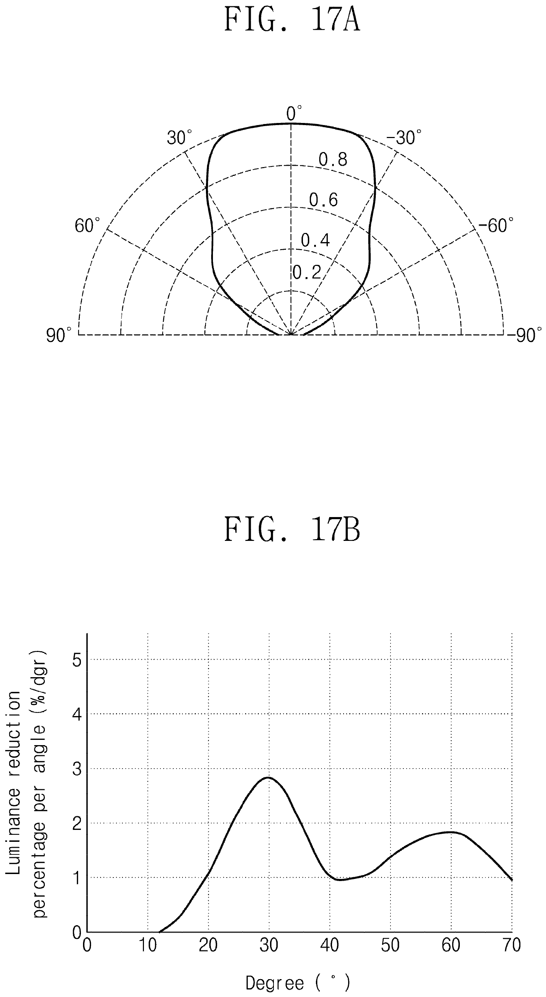

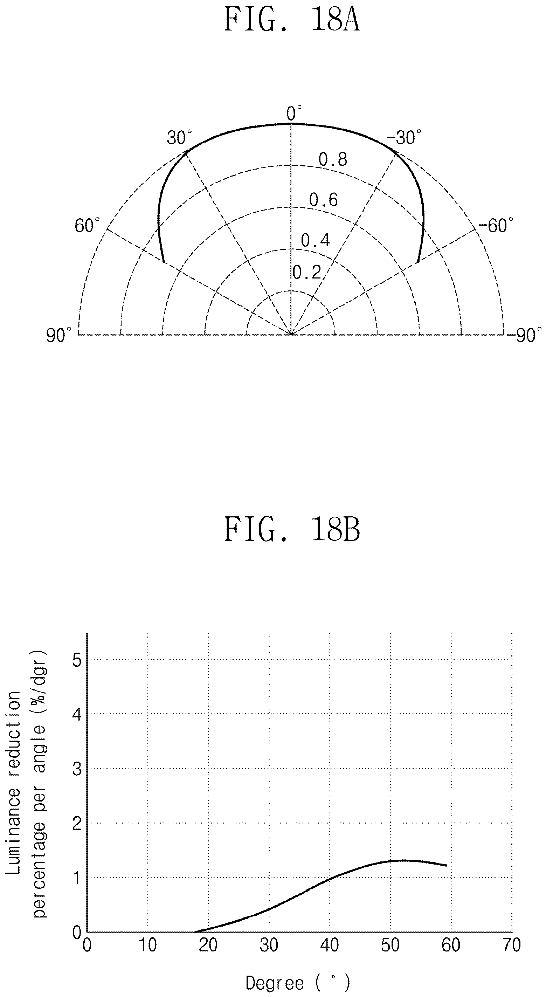

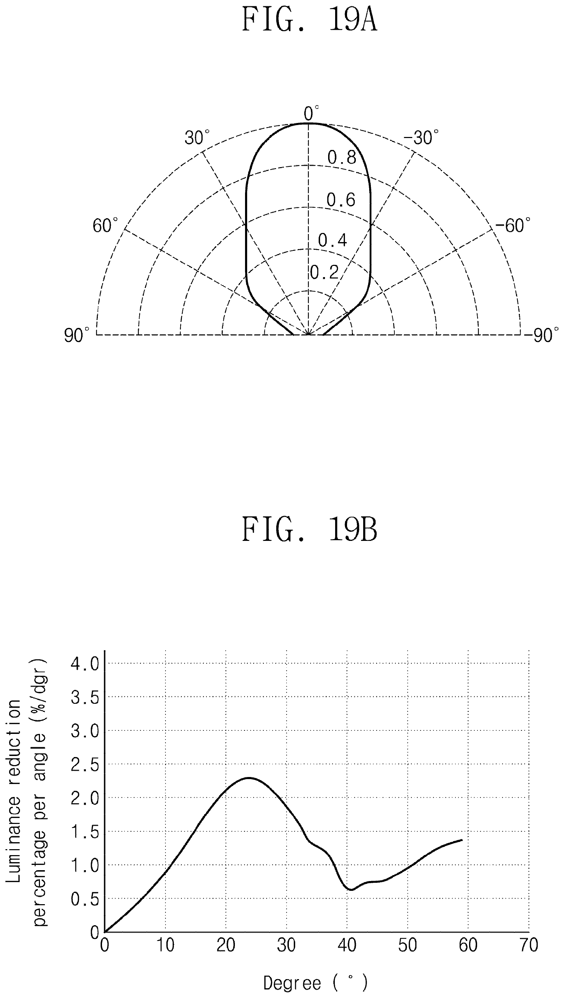

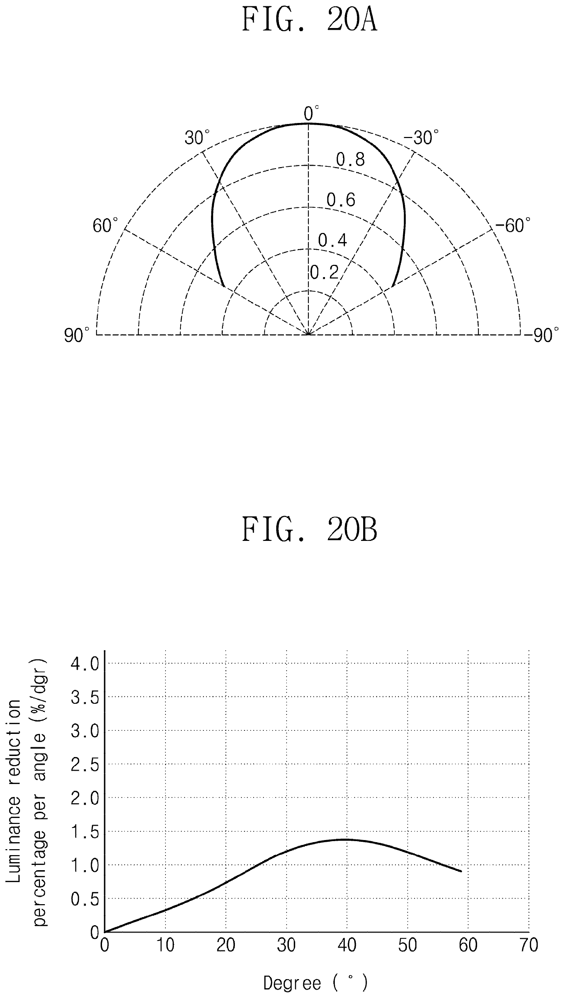

FIGS. 16A to 16C are resonance graphs according to comparative example 2. FIGS. 16A to 16C are resonance graphs of a display device of comparative example 2. FIG. 17A is a graph of luminance distribution of a substrate mode according to comparative example 2. FIG. 17B is a graph of luminance reduction percentage per angle of the substrate mode according to comparative example 2. FIG. 18A is a graph of luminance distribution of an air mode according to comparative example 2. FIG. 18B is a graph of luminance reduction percentage per angle of the air mode according to comparative example 2. FIG. 19A is a graph of luminance distribution of the substrate mode according to comparative example 2. FIG. 19B is a graph of luminance reduction percentage per angle of the substrate mode according to comparative example 2. FIG. 20A is a graph of luminance distribution of the air mode according to comparative example 2. FIG. 20B is a graph of luminance reduction percentage per angle of the air mode according to comparative example 2.

FIGS. 16A to 16C are resonance graphs in which a display module of comparative example 2 different from the display module DM according to some embodiments of the present invention is applied. FIG. 16A is a resonance graph in a red pixel, FIG. 16B is a resonance graph in a green pixel, and FIG. 16C is a resonance graph in a blue pixel. In FIGS. 16A to 16C, the y-axis represents the luminance of light normalized based on 3, and the x-axis represents the depth to the first inorganic layer (-500 nm (-5000 Å)) based on the third electrode (0 nm (0 Å)).

The display module applied to the display device of FIGS. 16A to 16C has the same or substantially the same structure as the display module DM according to the embodiment of FIG. 7, except that a multi-layer structure of LiF (40 nm (400 Å))/SiNₓ (135 nm (1350 Å))/SiON (1000 nm (10000 Å)) is applied as the first inorganic layer on the capping layer and AgMg (9,5 nm (95 Å)) is applied as the second electrode. A particular structure is shown in Table 3.

**Table 3**

| | Thickness (nm (Å)) | | |
|---|---|---|---|
| Functional layer | Red pixel | Green pixel | Blue pixel |
| Capping layer | 89 (890) | 89 (890) | 89 (890) |
| Second electrode | 9,5 (95) | 9,5 (95) | 9,5 (95) |
| Electron transport region | 43,5 (435) | 43,5 (435) | 43,5 (435) |
| Light emitting layer | 42 (420) | 38 (380) | 19 (190) |
| Hole transport region | 35 (350) | 20 (200) | 15 (150) |
| First electrode | 107 (1070) | 107 (1070) | 107 (1070) |

Referring to FIGS. 16A to 16C, light emitted from light emitting layers may undergo primary resonance between the first electrode and the second electrode. FIGS. 16A to 16C of comparative example 2 are the same as or substantially the same as FIGS. 8A to 8C of some embodiments of the present invention in terms of primary resonance. However, in the embodiments in which the single-layer resonance relaxation structure is applied to the first inorganic layer of the encapsulation layer, a reduction in luminance is small. FIGS. 17A to 18B illustrate a graph of luminance distribution or a graph of luminance reduction percentage per angle when a color filter is not applied to the structure of the display module of comparative example 2. FIG. 17A is a graph of luminance distribution of the substrate mode of the display module of comparative example 2, and FIG. 17B is a graph of luminance reduction percentage per angle of the substrate mode. The graph of luminance distribution and the graph of luminance reduction percentage per angle are based on the luminance of light emitted in the direction from the display module toward the window module.

Referring to FIGS. 17A and 17B, the luminance reduction percentage per angle may be up to about 2.84% / dgr.

Accordingly, as illustrated in FIGS. 18A and 18B, the radiation form of the air mode of light emitted to the front may appear, and i the luminance reduction percentage per angle may be up to about 1.29% / dgr.

FIGS. 19A to 20B illustrate a graph of luminance distribution or a graph of luminance reduction percentage per angle when a color filter is applied to the structure of the display module of comparative example 2.

Referring to FIGS. 19A and 19B, the luminance reduction percentage per angle may be up to about 2.36% / dgr.

Accordingly, as illustrated in FIGS. 20A and 20B, the radiation form of the air mode of light emitted to the front may appear, and the luminance reduction percentage per angle may be up to about 1.41% / dgr.

For example, in the case of the display device to which the display module of comparative example 2 is applied, the luminance reduction percentage per angle of light emitted from the display module is high. Accordingly, in the case of the display device of comparative example 2, light emitted from the display module may not be uniformly viewed depending on angles after passing through the window module including the curved region, and light leakage may occur.

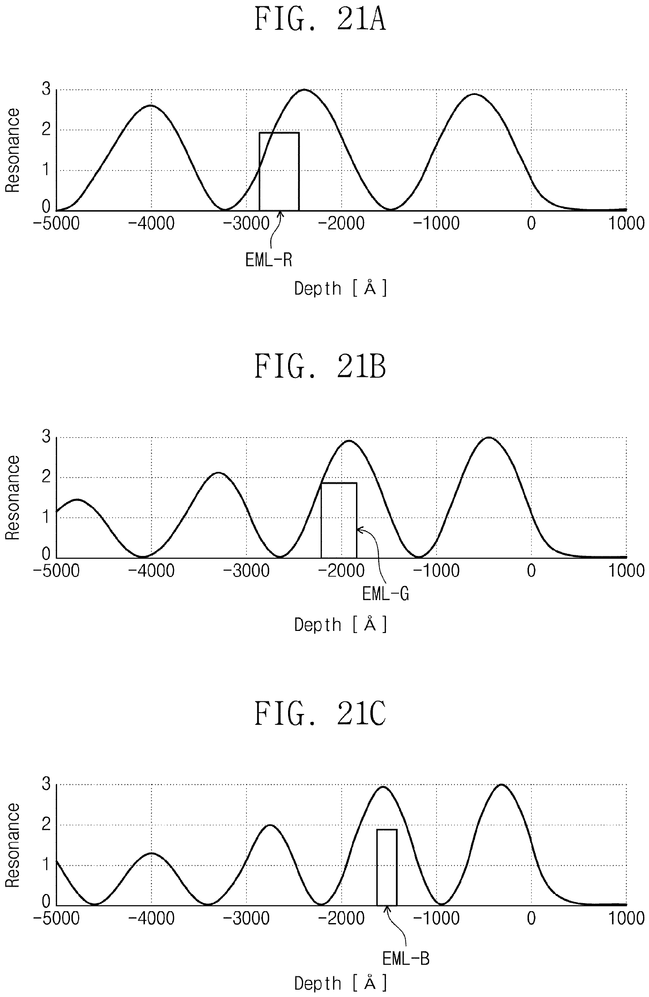

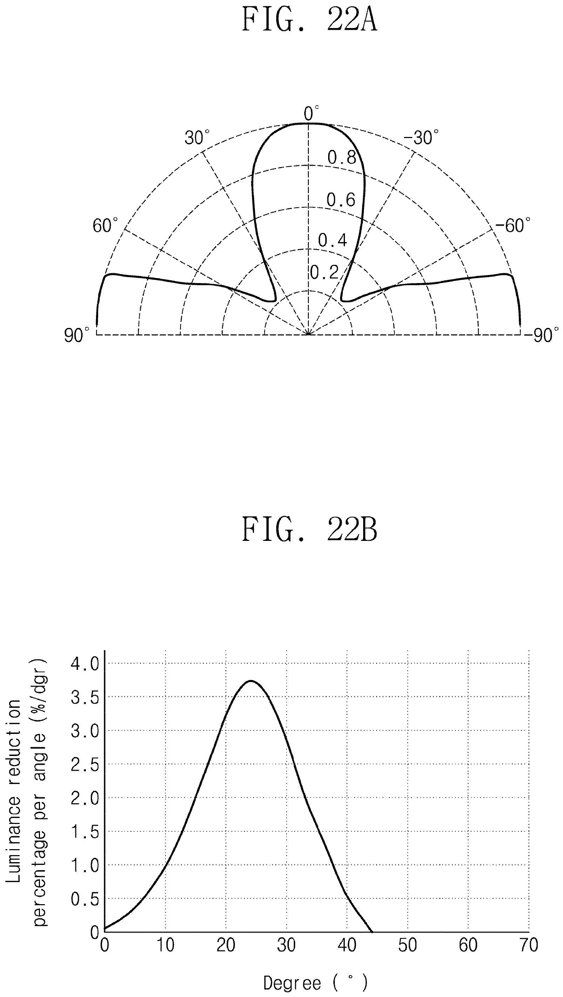

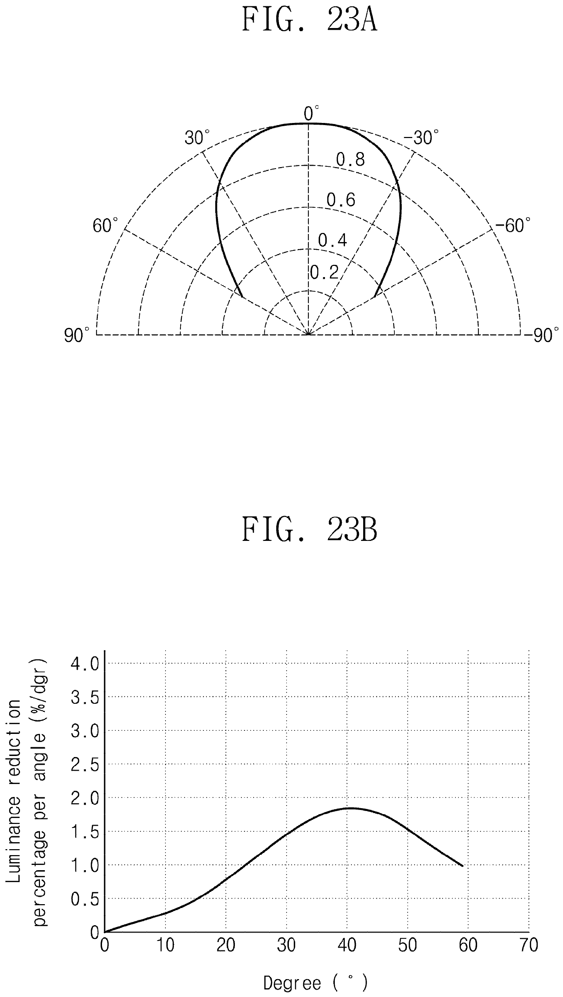

FIGS. 21A to 21C are resonance graphs according to comparative example 3. FIGS. 21A to 21C are resonance graphs of a display device of comparative example 3. FIG. 22A is a graph of luminance distribution of a substrate mode according to comparative example 3. FIG. 22B is a graph of luminance reduction percentage per angle of the substrate mode according to comparative example 3. FIG. 23A is a graph of luminance distribution of an air mode according to comparative example 3. FIG. 23B is a graph of luminance reduction percentage per angle of the air mode according to comparative example 3.

FIGS. 21A to 21C are resonance graphs in which a display module of comparative example 3 different from the display module DM according to the embodiment of the present invention is applied. FIG. 21A is a resonance graph in a red pixel, FIG. 21B is a resonance graph in a green pixel, and FIG. 21C is a resonance graph in a blue pixel. In FIGS. 21A to 21C, the y-axis represents the luminance of light normalized based on 3, and the x-axis represents the depth to the first inorganic layer (-500 nm (-5000 Å)) based on the third electrode (0 nm (0 Å)).

The display module applied to the display device of FIGS. 21A to 21C has the same or substantially the same structure as the display module DM-ref1 of comparative example 1, except that IZO (66 nm (660 Å)) is applied as the second electrode.

Referring to FIGS. 21A to 21C, light emitted from light emitting layers may undergo secondary resonance between the first electrode and the second electrode. When FIGS. 21A to 21C of comparative example 3 are compared with FIGS. 13A to 13C of comparative example 1, a reduction in luminance is small in comparative example 3 in which the second electrode is a transparent IZO electrode.

FIG. 22A is a graph of luminance distribution of the substrate mode of the display module of comparative example 3, and FIG. 22B is a graph of luminance reduction percentage per angle of the substrate mode. The graph of luminance distribution and the graph of luminance reduction percentage per angle are based on the luminance of light emitted in the direction from the display module toward the window module.

Referring to FIGS. 22A and 22B, side lobes may occur and the luminance reduction percentage per angle may be up to about 3.73% / dgr.

Accordingly, as illustrated in FIGS. 23A and 23B, the radiation form of the air mode of light emitted to the front may appear, and the luminance reduction percentage per angle may be up to about 1.85% / dgr.

For example, in the case of the display device to which the display module of comparative example 3 is applied, the luminance reduction percentage per angle of light emitted from the display module is high. Accordingly, in the case of the display device of comparative example 3, light emitted from the display module may not be uniformly viewed depending on angles after passing through the window module including the curved region, and light leakage may occur. According to some embodiments, the display device of the present invention may have the resonance relaxation structure in which light emitted from the light emitting layer undergoes primary resonance, and thus light leakage from the periphery of the display device including the curved surface may be reduced.

While the present invention has been described with reference to one or more embodiments thereof, it will be apparent to those of ordinary skill in the art that one or more suitable changes and modifications may be made thereto without departing from the scope of the present invention as set forth in the following claims.

## Claims

1. A display device (DD) comprising:
a display module (DM); and
a window module (WM) on the display module (DM), the window module (WM) comprising a front surface (WFS) comprising a flat region (FA) and a curved region (RA) around the flat region (FA),
the display module (DM) comprising:
a base layer (BS);
a light emitting element layer (EDL) on the base layer (BS), the light emitting element layer (EDL) comprising a light emitting element, the light emitting element comprising a first electrode (EL1), a second electrode (EL2) on the first electrode (EL1) and comprises transparent conductive metal oxide, and a light emitting layer (EML) between the first electrode (EL1) and the second electrode (EL2), and a distance (d_{R1}, d_{G1}, d_{B1}) between the first electrode (EL1) and the second electrode (EL2) is a primary resonance distance for light emitted from the light emitting layer (EML);
an encapsulation layer (TFE) on the light emitting element layer (EDL), and comprising:
a single first inorganic layer (INL1) directly on the light emitting element layer (EDL);
an organic layer (OL) on the first inorganic layer (INL1); and
a second inorganic layer (INL2) on the organic layer (OL); and
a color filter layer (CFL) on the encapsulation layer (TFE).

2. The display device (DD) of claim 1, wherein the distance (d_{R1}, d_{G1}, d_{B1}) between the first electrode (EL1) and the second electrode (EL2) is in a range from about 70 nm to about 130 nm.

3. The display device (DD) of claim 1 or 2, wherein the light emitting layer (EML) has a refractive index of 1.8 to 1.95.

4. The display device (DD) of at least one of claims 1 to 3, wherein the light emitting element further comprises a hole transport region (HTR) between the first electrode (EL1) and the light emitting layer (EML), and
wherein a distance (d_{R2}, d_{G2}, d_{B2}) between the first electrode (EL1) and the light emitting layer (EML) is in a range from about 10 nm to about 40 nm.

5. The display device (DD) of at least one of claims 1 to 4, wherein the light emitting element further comprises an electron transport region (ETR) between the light emitting layer (EML) and the second electrode (EL2), and
wherein the hole transport region (HTR) and the electron transport region (ETR) have a refractive index of about 1.8 to about 2.0.

6. The display device (DD) of at least one of claims 1 to 5, wherein the second electrode (EL2) comprises at least one of indium zinc oxide, IZO, indium tin oxide, ITO, zinc oxide, ZnO, or indium tin zinc oxide, ITZO.

7. The display device (DD) of at least one of claims 1 to 6, wherein the second electrode (EL2) has a thickness of about 50 nm to about 80 nm.

8. The display device (DD) of at least one of claims 1 to 7, wherein the display module (DM) further comprises a polarizer film on the color filter layer (CFL).

9. The display device (DD) of at least one of claims 1 to 8, wherein a luminance reduction percentage per angle within the window module (WM) of light emitted from the display module (DM) is about 2% / dgr or less based on luminance of light emitted in a direction parallel to a direction from the display module (DM) to the window module (WM).

10. The display device (DD) of at least one of claims 1 to 9, wherein a luminance reduction percentage per angle of light emitted from the display module (DM) and outputted through the window module (WM) is about 1% / dgr or less based on luminance of light emitted in a direction parallel to a direction from the display module (DM) to the window module (WM).

11. The display device (DD) of at least one of claims 1 to 10, wherein the light emitting layer (EML) comprises a first light emitting layer (EML1) and a second light emitting layer (EML2) on the first light emitting layer (EML1).
